# EUROPÄISCHE PATENTANMELDUNG

(11) **EP 4 578 632 A1**
(43) Veröffentlichungstag der Anmeldung: **02.07.2025**
(21) Anmeldenummer: 23220562.5
(22) Anmeldetag: 28.12.2023
(51) Int. Cl.: B29C 64/124, B29C 64/106, B29C 64/10, G03F 7/20

(54) **ADDITIVE FERTIGUNG VON FOTOPOLYMERPLATTEN**

(71) Anmelder: AKK GmbH, 47809 Krefeld (DE)
(72) Erfinder: KESPER, Peer, 47800 Krefeld (DE)
(74) Vertreter: Cohausz & Florack

(57) **Zusammenfassung**

Die Erfindung betrifft unter anderem ein Verfahren (100) zur Herstellung einer Fotopolymerplatte (350, 500). Die Aufgabe, ein gegenüber dem Stand der Technik einfacheres und effizienteres Verfahren zur Herstellung einer Fotopolymerplatte bereitzustellen, wird dadurch gelöst, dass das Verfahren umfasst:
- Erzeugen (110) einer ersten Schicht (341) eines flüssigen Fotopolymers (340);
- Erzeugen (112) eines oder mehrerer gehärteter Bereiche (351) der ersten Schicht (341) durch selektives Belichten der ersten Schicht (341);
- Erzeugen (114) einer zweiten Schicht (342) des flüssigen Fotopolymers (340) auf derjenigen Seite der ersten Schicht, welche dem Lichteinfall für das selektive Belichten der ersten Schicht (341) zugewandt ist;
- Erzeugen (116) eines oder mehrerer gehärteter Bereiche (352) der zweiten Schicht (352) durch selektives Belichten der zweiten Schicht (352), wobei sich mindestens ein gehärteter Bereich (352) der zweiten Schicht mit mindestens einem gehärteten Bereich (351) der ersten Schicht verbindet.

## Beschreibung

Die vorliegende Erfindung betrifft ein Verfahren und eine Vorrichtung zur Herstellung einer Fotopolymerplatte sowie ein Computerprogrammprodukt.

Ein Fotopolymer ist ein lichtempfindliches Polymer, welches bei Bestrahlung mit Licht bestimmter Wellenlängen seine Eigenschaften verändert. Insbesondere kann dabei als strukturelle Änderung eine photochemische Härtung des Materials aufgrund von Fotopolymerisation und/oder Vernetzung auftreten. Hierdurch wird aus einem vormals flüssigen oder festen, aber vergleichsweise weichen Fotopolymer ein festes, gehärtetes Fotopolymer. Bei den heute üblichen Fotopolymeren tritt eine solche Härtung typischerweise bei Bestrahlung mit Licht aus dem UV-VIS-Bereich des elektromagnetischen Spektrums auf. Es existieren jedoch auch Fotopolymere, bei denen die Härtung bei anderen Wellenlängen, beispielsweise aus dem IR-Bereich, auftritt. Vor diesem Hintergrund ist der Begriff "Licht" im Rahmen der hier beschrieben Erfindung so zu verstehen, dass er nicht nur elektromagnetische Strahlung im sichtbaren Wellenlängenbereich (VIS) umfasst, sondern darüber hinaus auch Strahlung aus sämtlichen Wellenlängenbereichen, die zum Härten von Fotopolymeren verwendet werden können, insbesondere Strahlung aus den Bereichen des Ultraviolett (UV) sowie des Infrarot (IR).

Fotopolymere werden bereits heute zur Herstellung von sogenannten Fotopolymerplatten verwendet. Hierbei handelt es sich um flexible Platten, die als Druckformen, insbesondere im Bereich des Flexodrucks, oder als Prägeformen eingesetzt werden. Der Flexodruck ist ein Hochdruckverfahren, bei dem die druckenden Bereiche auf einer höheren Ebene der Druckform liegen als die nicht druckenden Bereiche. Das Prinzip zur Herstellung einer Flexodruckform in Form einer Fotopolymerplatte besteht darin, dass ein selektives Belichten erfolgt. Hierbei werden die druckenden Bereiche belichtet und somit gehärtet. Hingegen bleiben die nicht druckenden Bereiche unbelichtet, sodass das ungehärtete Fotopolymer anschließend aus diesen Bereichen ausgewaschen werden kann. Ähnlich wie Flexodruckformen weisen auch Prägeformen eine strukturierte Oberfläche mit mehreren Ebenen auf, welche jedoch nicht dem späteren Druckbild, sondern der zu prägenden Struktur entspricht. Folglich kann ein Prägeform in Form einer Fotopolymerplatte ebenfalls durch selektives Belichten und anschließendes Auswaschen hergestellt werden.

In einem gemäß heutigem Stand der Technik häufig eingesetzten Verfahren zur Herstellung von Fotopolymerplatten wird eine nicht gehärtete Fotopolymerplatte, deren Dicke beispielsweise 1,2 mm beträgt, zunächst auf ihrer Rückseite vollflächig belichtet. Auf diese Weise wird ein Fundament aus gehärtetem Fotopolymer gebildet, mit dem sich die später auf der Vorderseite hergestellten Strukturen verbinden können. Das Fundament hat beispielsweise eine Dicke, die der halben Dicke der Fotopolymerplatte entspricht. Zur Herstellung der vorderseitigen Strukturen, welche dem Druckbild oder Prägebild entsprechen, weist die Fotopolymerplatte auf ihrer Vorderseite eine opake Schicht auf, welche zumindest für einen Teil der zum Härten des Fotopolymers verwendeten Wellenlängen lichtundurchlässig ist. Aus dieser opaken Schicht wird eine Negativmaske hergestellt, indem die opake Schicht an den Stellen, an denen das Fotopolymer gehärtet werden soll, abgetragen wird. Für das Abtragen kann beispielsweile ein Laser, insbesondere ein Fiber Laser, verwendet werden. Anschließend wird die Vorderseite der Fotopolymerplatte durch die hergestellte Negativmaske hindurch selektiv belichtet. Dabei wird das Fotopolymer an den Stellen, an denen die opake Schicht zuvor abgetragen wurde, belichtet, sodass dort gehärtetes Fotopolymer entsteht. An den Stellen, an denen die opake Schicht nicht abgetragen wurde, bleibt das Fotopolymer hingegen unbelichtet, sodass hier keine Härtung auftritt. Die Härtung der belichteten Bereiche erfolgt ausgehend von der vorderseitigen Oberfläche des Fotopolymers bis zu einer Dicke, bei der sich die entstehenden Strukturen des gehärteten Fotopolymers mit dem zuvor hergestellten Fundament verbinden. Auf diese Weise werden die hergestellten Strukturen, welche dem Druckbild oder dem Prägebild entsprechen, örtlich fixiert und stabilisiert. Während des gesamten Belichtungsvorgangs liegt die Fotopolymerplatte typischerweise ruhend in einer Belichtungsanlage, in der die vorderseitige und rückseitige Belichtung erfolgt. Nach Beendigung des Belichtungsvorgangs wird das in den nicht belichteten Bereichen verbleibende nicht gehärtete Fotopolymer schließlich ausgewaschen, sodass auf diese Weise beispielsweise eine Flexodruckform mit erhabenen druckenden Bereichen und tieferliegenden nicht druckenden Bereichen, oder eine entsprechende Prägeform entsteht.

Nachteilig an dem soeben beschrieben Verfahren des Stands der Technik ist jedoch, dass die Herstellung der Negativmaske aufwendig und zeitintensiv ist. Zum einen werden für die Herstellung der Negativmaske, beispielsweise durch selektives Abtragen der opaken Schicht mit einem Laser, spezielle Apparaturen, insbesondere Laseranlagen, benötigt, welche einen großen Raumbedarf aufweisen. Zum anderen nimmt die Herstellung der Negativmaske in dem oben beschriebenen Verfahren einen beachtlichen Teil der gesamten Fertigungszeit der Fotopolymerplatte in Anspruch. Typischerweise werden für die Herstellung der Negativmaske etwa 20 Minuten benötigt, während die Gesamtzeit für die Fertigung der Fotopolymerplatte nur etwa 50 Minuten beträgt. Schließlich muss das ausgewaschene Fotopolymer aufwendig entsorgt werden und insbesondere bei Fotopolymerplatten, bei denen ein vergleichsweise großer Teil des Fotopolymers nicht ausgehärtet wird, führt dies zu einem ineffizienten Ressourceneinsatz sowie zu unnötigen Kosten und zu einer vermeidbaren Umweltbelastung.

Vor diesem Hintergrund liegt der vorliegenden Erfindung die Aufgabe zugrunde, ein einfacheres und effizienteres Verfahren zur Herstellung einer Fotopolymerplatte bereitzustellen. Daneben liegt der Erfindung auch die Aufgabe zugrunde, eine entsprechende Vorrichtung und ein entsprechendes Computerprogrammprodukt anzugeben.

Gemäß einer ersten Lehre der vorliegenden Erfindung wird die oben genannte Aufgabe für ein Verfahren zur Herstellung einer Fotopolymerplatte dadurch gelöst, dass das Verfahren umfasst:
- Erzeugen einer ersten Schicht eines flüssigen Fotopolymers;
- Erzeugen eines oder mehrerer gehärteter Bereiche der ersten Schicht durch selektives Belichten der ersten Schicht;
- Erzeugen einer zweiten Schicht des flüssigen Fotopolymers auf derjenigen Seite der ersten Schicht, welche dem Lichteinfall für das selektive Belichten der ersten Schicht zugewandt ist;
- Erzeugen eines oder mehrerer gehärteter Bereiche der zweiten Schicht durch selektives Belichten der zweiten Schicht, wobei sich mindestens ein gehärteter Bereich der zweiten Schicht mit mindestens einem gehärteten Bereich der ersten Schicht verbindet.

Das auf diese Weise definierte erfindungsgemäße Verfahren entspricht einem additiven Fertigungsverfahren, bei dem horizontale Schichten aus einem flüssigen Fotopolymer nacheinander erzeugt und durch selektives Belichten bereichsweise gehärtet werden. In der einfachsten Ausgestaltung des erfindungsgemäßen Verfahrens werden eine erste und eine zweite Schicht erzeugt und selektiv belichtet. Grundsätzlich kann mit dem Verfahren jedoch eine beliebige Anzahl zusammenhängender Schichten auf iterative Weise erzeugt und selektiv belichtet werden. Hierzu muss lediglich für jede weitere Schicht analog verfahren werden wie für die unmittelbar zuvor erzeugte und selektiv belichtete Schicht.

Unter einem selektiven Belichten einer Schicht des flüssigen Fotopolymers wird im Rahmen der hier beschrieben Erfindung verstanden, dass die dem Lichteinfall ausgesetzte Oberfläche der jeweiligen Schicht nicht zwangsweise vollflächig belichtet wird, sondern dass durch Verwendung einer maskierten Lichtquelle lediglich ein oder mehrere ausgewählte Bereiche der Oberfläche belichtet werden. In den belichteten Bereichen erfolgt eine Härtung des flüssigen Fotopolymers durch Fotopolymerisation und/oder Vernetzung, sodass dementsprechend ein oder mehrere gehärtete Bereiche der jeweiligen Schicht erzeugt werden. Hingegen können ein oder mehrere andere Bereiche der Oberfläche von der Belichtung ausgenommen werden. In den ausgenommenen Bereichen erfolgt für die betreffende Schicht keine Härtung des flüssigen Fotopolymers. Das selektive Belichten kann für eine oder mehrere Schichten auch in einem vollflächigen Belichten bestehen, wenn die gewünschte Struktur der Fotopolymerplatte dies erfordert.

Unter einem Härten des flüssigen Fotopolymers wird im Rahmen der hier beschrieben Erfindung verstanden, dass das flüssige Fotopolymer zumindest vom flüssigen in einen festen Zustand übergeht und dabei zumindest so weit gehärtet wird, dass es formstabil ist. Es ist dabei nicht zwingend erforderlich, dass das Fotopolymer bereits eine maximal mögliche Härte aufweist. Diese kann beispielsweise erst durch eine Nachbelichtung erreicht werden.

Dadurch, dass in dem erfindungsgemäßen Verfahren die einzelnen Schichten aus flüssigem Fotopolymer selektiv belichtet werden, kann die Herstellung einer Negativmaske durch Abtragen einer opaken Schicht entfallen. Stattdessen kann das selektive Belichten der einzelnen Schichten auf andere Weise, wie beispielsweise durch einen nachfolgend noch näher erläuterten Flächenlichtmodulator, erfolgen. Somit entfällt nicht nur der zusätzliche apparative Aufwand und der damit verbundene Raumbedarf für die zum Abtragen der opaken Schicht bisher verwendeten Lasersysteme. Auch die Anzahl der Prozessschritte sowie die Gesamtzeit für die Herstellung einer Fotopolymerplatte kann dadurch reduziert werden. Daneben verursacht das erfindungsgemäße Verfahren gegenüber dem Stand der Technik auch weniger Abfall und ist dadurch kostengünstiger, ressourceneffizienter und umweltschonender.

Ein weiterer Vorteil des erfindungsgemäßen Verfahrens besteht darin, dass zusätzliche Möglichkeiten hinsichtlich der herzustellenden Strukturen einer Flexodruckform oder einer Prägeform entstehen. Beispielsweise können mit dem erfindungsgemäßen Verfahren Strukturen hergestellt werden, deren Querschnitt sich in Richtung der Rückseite der Fotopolymerplatte nicht vergrößert. Mit dem eingangs beschriebenen Verfahren des Stands der Technik ist dies bisher nicht möglich. Dies ist dadurch begründet, dass das in einem Verfahrensschritt zu härtende Fotopolymer eine vergleichsweise großen Dicke aufweist, sodass Licht durch Streueffekte auch in die maskierten Bereiche eindringt. Aufgrund dessen tritt dort ebenfalls eine Härtung auf und die gehärteten Strukturen weisen dadurch einen zunehmend größeren Querschnitt in Richtung der Rückseite der Fotopolymerplatte auf. In dem erfindungsgemäßen Verfahren hingegen ist die Dicke des in einem Verfahrensschritt zu härtenden Fotopolymers aufgrund der Unterteilung in Schichten deutlich kleiner, sodass sich Streueffekte dort praktisch nicht auswirken. Strukturen, deren Querschnitt sich in Richtung der Rückseite der Fotopolymerplatte nicht vergrößert, haben den Vorteil, dass die Räume zwischen den Strukturen beim Drucken mehr Farbe aufnehmen können. Hierdurch ist es nicht so häufig erforderlich, die Druckform zu reinigen, d.h. die Druckfarbe von der Druckform zu entfernen, was jedes Mal einen Stillstand der Druckanlage mit sich bringt.

Zudem können auch Strukturen unterschiedlicher Höhe mit dem erfindungsgemäßen Verfahren auf besonders einfache Weise hergestellt werden. Derartige Strukturen können beispielsweise im Flexodruck vorteilhaft sein, um insbesondere bei flächigen Druckelementen und vergleichsweise niedrigem Farbauftrag ein besseres Druckergebnis zu erzielen. Beispielsweise können hierzu einige der zylindrischen Strukturen, die den einzelnen Bildpunkten eines gerasterten Bereichs entsprechen, eine geringere Höhe als die benachbarten Strukturen aufweisen. Eine solche Struktur geringerer Höhe wird als "undercut" oder "flat dot" bezeichnet. Mit dem eingangs beschriebenen Verfahren des Stands der Technik ist die resultierende Höhe jeder einzelnen Struktur am Ende des Belichtungsvorgangs zunächst gleich, was der Belichtung durch die Negativmaske hindurch geschuldet ist. Zur Herstellung von Strukturen geringerer Höhe ("undercut") sind somit weitere Verfahrensschritte erforderlich, was einen zusätzlichen Aufwand mit sich bringt. Mit dem erfindungsgemäßen Verfahren hingegen können Strukturen geringerer Höhe auf einfache Weise dadurch hergestellt werden, dass der entsprechende Bereich bei mindestens einer als letztes erzeugten und selektiv belichteten Schicht von der Belichtung ausgenommen wird, sodass dort keine Härtung des Fotopolymers auftritt.

In einer bevorzugten Ausführungsform des erfindungsgemäßen Verfahrens verbindet sich beim Erzeugen des einen oder der mehreren gehärteten Bereiche der ersten Schicht mindestens ein gehärteter Bereich der ersten Schicht mit einer vollflächigen Trägerschicht. Vorzugsweise verbinden sich alle gehärteten Bereiche der ersten Schicht mit der Trägerschicht. Bei der Trägerschicht kann es sich beispielsweise um eine Folie aus einem gewöhnlichen Polymer, bei dem im Falle einer Belichtung keine photochemische Härtung erfolgt, handeln. Alternativ kann auch eine aus Fotopolymer bestehende Trägerschicht noch vor dem Erzeugen der ersten Schicht hergestellt werden, indem eine Schicht des flüssigen Fotopolymers erzeugt, vollflächig belichtet und damit gehärtet wird. Durch die Verwendung einer vollflächigen Trägerschicht, mit der sich mindestens ein gehärteter Bereich der ersten Schicht verbindet, kann erreicht werden, dass der eine oder die mehreren gehärteten Bereiche der ersten Schicht örtlich fixiert werden. Damit können der eine oder die mehreren gehärteten Bereiche der ersten Schicht insbesondere gemeinsam bewegt werden. Darüber hinaus kann eine vollflächige Trägerschicht auch die mechanische Stabilität der hergestellten Fotopolymerplatte verbessern.

Das Erzeugen der ersten Schicht und/oder der zweiten Schicht kann grundsätzlich auf vielfältige Art und Weise erfolgen. In einer Ausführungsformen des erfindungsgemäßen Verfahrens kann die erste Schicht beispielsweise durch Aufsprühen von flüssigem Fotopolymer auf die Trägerschicht erzeugt werden. Die zweite Schicht kann in dieser Ausführungsform beispielsweise ebenfalls durch Aufsprühen von flüssigem Fotopolymer auf die bereichsweise gehärtete erste Schicht erzeugt werden. Das Aufsprühen der ersten und/oder zweiten Schicht stellt eine einfache und prozesssichere Möglichkeit zum Erzeugen der jeweiligen Schicht dar. Allerdings kann es hierbei erforderlich sein, dass entsprechende Sprühvorrichtungen für das selektive Belichten der jeweiligen Schicht wieder aus dem Strahlengang entfernt werden müssen.

In einer bevorzugten Ausführungsform des erfindungsgemäßen Verfahrens befindet sich das flüssige Fotopolymer in einem Gefäß mit einem zumindest teilweise transparenten Begrenzungselement. In dieser Ausführungsform trifft das Licht zum selektiven Belichten der ersten Schicht und/oder zum selektiven Belichten der zweiten Schicht von außen auf das zumindest teilweise transparente Begrenzungselement des Gefäßes und durchdringt das zumindest teilweise transparente Begrenzungselement zumindest teilweise. Ferner wird die zweite Schicht in dieser Ausführungsform dadurch erzeugt, dass die Trägerschicht zusammen mit dem mindestens einen mit der Trägerschicht verbundenen gehärteten Bereich der ersten Schicht so bewegt wird, dass sich der Abstand zwischen der Trägerschicht und dem zumindest teilweise transparenten Begrenzungselement vergrößert, sodass flüssiges Fotopolymer in das hierdurch entstehende Volumen strömt. Durch die genannten Merkmale kann das erfindungsgemäße Verfahren auf besonders effiziente und vorteilhafte Weise durchgeführt werden. Insbesondere wird die Handhabbarkeit des flüssigen Fotopolymers dadurch verbessert, dass sich das flüssige Fotopolymer in einem Gefäß befindet. Durch das zumindest teilweise transparente Begrenzungselement des Gefäßes kann trotzdem eine selektive Belichtung des flüssigen Fotopolymers sichergestellt werden, um dieses bereichsweise zu härten. Unter einem zumindest teilweise transparenten Begrenzungselement wird in diesem Zusammenhang ein Begrenzungselement verstanden, welches zumindest für einen Teil der für das Härten des Fotopolymers erforderlichen Wellenlängen lichtdurchlässig ist. Bei dem zumindest teilweise transparenten Begrenzungselement kann es sich beispielsweise um eine zumindest teilweise transparente Platte handeln, welche parallel zu den erzeugten und selektiv belichteten Schichten des flüssigen Fotopolymers ausgerichtet ist, und welche umfangsseitig gegen das Gefäß abgedichtet ist. Durch das Bewegen der Trägerschicht und das dadurch bewirkte Nachströmen des flüssigen Fotopolymers kann die zweite Schicht auf einfache Weise, aber dennoch prozesssicher erzeugt werden. Die Trägerschicht kann dabei beispielsweise von einer beweglichen Halteeinrichtung gehalten und bewegt werden. Sprühvorrichtungen, welche unter Umständen wieder aus dem Strahlengang entfernt werden müssen, sind hierbei nicht erforderlich. Bevorzugt erfolgt das Bewegen der Trägerschicht in vertikaler Richtung. Dementsprechend sind das teilweise transparente Begrenzungselement in Form einer zumindest teilweise transparenten Platte sowie die erzeugten und selektiv belichteten Schichten des flüssigen Fotopolymers vorzugsweise horizontal ausgerichtet.

In einer bevorzugten Ausführungsform des erfindungsgemäßen Verfahrens wird die Trägerschicht zusammen mit dem mindestens einen mit der Trägerschicht verbundenen gehärteten Bereich der ersten Schicht entgegen der Schwerkraft bewegt. Unter einer Bewegung entgegen der Schwerkraft wird eine Bewegung verstanden, bei der die Trägerschicht insgesamt nach oben bewegt wird, also am Ende der Bewegung eine höhere potentielle Energie aufweist als zu Beginn der Bewegung. Die Bewegung kann auch einzelne nach unten gerichtete Bewegungsabschnitte enthalten, solange insgesamt eine Bewegung nach oben erfolgt, d.h. solange die nach oben insgesamt zurückgelegte Wegstrecke größer ist als die nach unten insgesamt zurückgelegte Wegstrecke. Entsprechend der Bewegung entgegen der Schwerkraft sind die erzeugten und selektiv belichteten Schichten des flüssigen Fotopolymers in der hier beschriebenen bevorzugten Ausführungsform oberhalb des zumindest teilweise transparenten Begrenzungselements des Gefäßes angeordnet und die Lichtstrahlen für das selektive Belichten treffen von unten auf das zumindest teilweise transparente Begrenzungselement. Grundsätzlich ist eine Durchführung des erfindungsgemäßen Verfahrens auch in einer horizontal gespiegelten Anordnung der genannten Komponenten denkbar, bei der die Trägerschicht dann entlang der Schwerkraft bewegt wird. In einer solchen Anordnung kann es jedoch erforderlich werden, dass bewegliche Komponenten einer Vorrichtung zur Durchführung des Verfahrens gegen das Gefäß abgedichtet werden müssen. Die hier beschriebene bevorzugte Ausführungsform, bei der die Trägerschicht entgegen der Schwerkraft bewegt wird, bringt somit den Vorteil eines besonders einfachen apparativen Aufbaus mit sich.

In einer bevorzugten Ausführungsform des erfindungsgemäßen Verfahrens wird für das selektive Belichten der ersten Schicht und/oder das selektive Belichten der zweiten Schicht mindestens eine LED, mindestens ein Laser oder mindestens eine Laserdiode als Lichtquelle verwendet. Beispielsweise kann ein LED-Array mit einer Vielzahl von parallel ausgerichteten LEDs als Lichtquelle verwendet werden. Beispielsweise kann ein Laser-Array mit einer Vielzahl von parallel ausgerichteten Lasern als Lichtquelle verwendet werden. Beispielsweise kann ein Laserdioden-Array mit einer Vielzahl von parallel ausgerichteten Laserdioden als Lichtquelle verwendet werden. LEDs, Laser und Laserdioden zeichnen sich durch hohe Lichtleistungen sowie eine hohe Lichtausbeute aus. Zudem sind sie in entsprechender Ausgestaltung in der Lage, Licht der für das Härten des Fotopolymers erforderlichen Wellenlängenbereiche, insbesondere UV-Licht, sichtbares Licht, und/oder IR-Licht bereitzustellen. Somit eignen sie sich in besonderem Maße für das selektive Belichten. Durch die parallele Anordnung einer Vielzahl von LEDs, Lasern oder Laserdioden in sogenannten Arrays kann eine einfache Skalierung der Lichtleistung erreicht werden.

In einer bevorzugten Ausführungsform des erfindungsgemäßen Verfahrens wird für das selektive Belichten der ersten Schicht und/oder das selektive Belichten der zweiten Schicht ein Flächenlichtmodulator verwendet. Insbesondere handelt es sich dabei um einen sogenannten DMD-Chip (engl.: digital micromirror device). Beispielsweise wird ein Lichtstrahlbündel auf den Flächenlichtmodulator gerichtet und von dort aus auf die selektiv zu belichtenden Schichten des flüssigen Fotopolymers projiziert. Ein DMD-Chip umfasst eine Vielzahl von matrixförmig angeordneten verkippbaren Mikrospiegeln mit einer Kantenlänge im Bereich von einigen µm. Jeder einzelne Mikrospiegel kann durch elektrostatische Felder, welche bei entsprechender elektronischer Ansteuerung des DMD-Chips erzeugt werden, zwischen zwei stabilen Endzuständen verkippt werden. Je nach Kippposition der Mikrospiegel werden kleine Ausschnitte des einfallenden Lichtstrahlbündels jeweils entweder in die Projektionsrichtung hinein oder aus der Projektionsrichtung heraus reflektiert. Dadurch, dass die einzelnen Mikrospiegel bis zu mehrere tausend Mal pro Sekunde ihre Kippposition verändern können, kann auf diese Weise sowohl eine zeitliche als auch eine örtliche Variation der Lichtintensität innerhalb des in Projektionsrichtung reflektierten Lichtstrahlbündels erreicht werden. Somit kann durch die Verwendung eines Flächenlichtmodulators, insbesondere eines DMD-Chips, ein selektives Belichten der einzelnen Schichten des flüssigen Fotopolymers erreicht werden.

In einer alternativen Ausführungsform des erfindungsgemäßen Verfahrens wird für das selektive Belichten der ersten Schicht und/oder das selektive Belichten der zweiten Schicht ein Flüssigkristallbildschirm (engl.: liquid crystal display, LCD) verwendet. Ein solcher Flüssigkristallbildschirm umfasst beispielsweise eine Vielzahl von Pixeln, welche beispielsweise eine quadratische Form aufweisen und unabhängig voneinander ihre Transparenz ändern können. Hierzu sind die Pixel beispielsweise sandwichartig aufgebaut und umfassen jeweils eine rückseitige Lichtquelle, insbesondere in Form einer LED oder einer Laserdiode, einen ersten Polarisationsfilter, eine erste transparente Platte, eine Flüssigkristallschicht, eine zweite transparente Platte und einen zweiten Polarisationsfilter. Die Lichtquelle sendet Licht mindestens eines für das Härten des Fotopolymers erforderlichen Wellenlängenbereichs aus. Zur Änderung der Transparenz eines Pixels wird mittels elektrischer Spannung die Ausrichtung der Flüssigkristalle gesteuert. In Abhängigkeit der Polarisationsrichtungen der beiden Polarisationsfilter und in Abhängig der Ausrichtung der Flüssigkristalle wird die Anordnung aus erstem Polarisationsfilter, Flüssigkristallschicht und zweitem Polarisationsfilter damit entweder durchlässig oder undurchlässig für das von der rückseitigen Lichtquelle ausgesandte Licht. Die unterschiedlichen Varianten sowie die genaue Funktionsweise eines Flüssigkristallbildschirms sind dem Fachmann bekannt, sodass hier nicht detaillierter darauf eingegangen wird. Durch die Verwendung eines Flüssigkristallbildschirms kann somit ebenfalls ein selektives Belichten der einzelnen Schichten des flüssigen Fotopolymers erreicht werden.

In einer Ausführungsform des erfindungsgemäßen Verfahrens erfolgt das selektive Belichten der ersten und zweiten Schicht, indem eine Belichtungseinrichtung die jeweils zu belichtende Fläche der ersten und zweiten Schicht zeilenweise abfährt. Hierdurch kann die Belichtungseinrichtung kleiner dimensioniert werden. In einer alternativen Ausführungsform erfolgt das selektive Belichten der ersten und zweiten Schicht, indem die gesamte zu belichtende Fläche der ersten und zweiten Schicht gleichzeitig belichtet wird. Auf diese Weise ist es nicht erforderlich, die jeweils zu belichtende Fläche zeilenweise abzufahren, sodass die insgesamt notwendige Zeit für das selektive Belichten reduziert und somit eine Fotopolymerplatte entsprechend schneller hergestellt werden kann. Zum gleichzeitigen Belichten der gesamten zu belichtenden Fläche können auch mehrere gleichartige Belichtungseinrichtungen nebeneinander verwendet werden.

In einer bevorzugten Ausführungsform des erfindungsgemäßen Verfahrens umfasst das Verfahren ferner:
- Erzeugen mindestens einer weiteren Schicht des flüssigen Fotopolymers auf derjenigen Seite der unmittelbar zuvor erzeugten Schicht, welche dem Lichteinfall für das selektive Belichten der unmittelbar zuvor erzeugten Schicht zugewandt ist;
- Erzeugen eines oder mehrerer gehärteter Bereiche der mindestens einen weiteren Schicht durch selektives Belichten der mindestens einen weiteren Schicht, wobei sich mindestens ein gehärteter Bereich der mindestens einen weiteren Schicht mit mindestens einem gehärteten Bereich der unmittelbar zuvor erzeugten Schicht verbindet.

Hierdurch kann mit dem erfindungsgemäßen Verfahren, wie oben bereits erwähnt, eine Fotopolymerplatte mit einer prinzipiell beliebigen Anzahl zusammenhängender Schichten hergestellt werden. Alle bisherigen Ausführungen betreffend das erfindungsgemäße Verfahren und seine bevorzugten Ausführungsformen gelten analog auch für jede der mindestens einen weiteren Schicht.

In einer bevorzugten Ausführungsform des erfindungsgemäßen Verfahrens weist mindestens ein gehärteter Bereich mindestens einer als letztes erzeugten Schicht eine Querschnittsfläche von höchstens 0,049 mm², bevorzugt höchstens 0,029 mm², besonders bevorzugt höchstens 0,016 mm² auf. Insbesondere weist eine Vielzahl von gehärteten Bereichen mindestens einer als letztes erzeugten Schicht, beispielsweise mindestens 50 oder mindestens 100 gehärtete Bereiche mindestens einer als letztes erzeugten Schicht, eine solche Querschnittsfläche auf. Beispielsweise können auch mehrere als letztes erzeugte Schichten jeweils mindestens einen gehärteten Bereich mit den genannten maximalen Querschnittsflächen aufweisen, wobei entsprechende Bereiche unterschiedlicher Schichten jeweils miteinander verbunden sind. Die Strukturen aus gehärtetem Fotopolymer, die auf diese Weise entstehen, können beispielsweise einen gerasterten Bereich einer Flexodruckform oder einer Prägeform bilden. Bei einem als kreisförmig angenommenen Querschnitt entsprechen die genannten Querschnittsflächen einem Durchmesser des mindestens einen gehärteten Bereichs von höchstens 0,25 mm, bevorzugt höchstens 0,19 mm, besonders bevorzugt höchstens 0,14 mm. Diese Durchmesser wiederum entsprechen unter der Annahme direkt benachbarter Bildpunkte einer Auflösung von mindestens 40 L/cm (Linien pro cm), bevorzugt mindestens 52 L/cm, besonders bevorzugt mindestens 70 L/cm. Im Flexodruck liegen typische Auflösungen des Druckbilds für gewöhnlich im Bereich zwischen 46 L/cm und 52 L/cm, beim sogenannten High-Definition-Flexodruck (HD Flexo) im Bereich zwischen 54 L/cm und 70 L/cm, und bei besonders hochauflösenden Anwendungen auch oberhalb von 70 L/cm, beispielsweise bei 100 L/cm oder mehr. Durch die oben genannten maximalen Querschnittsflächen kann damit sichergestellt werden, dass eine durch das erfindungsgemäße Verfahren hergestellte Flexodruckform in Form einer Fotopolymerplatte die typischen Anforderungen bezüglich der beim Druck zu erreichenden Auflösung erfüllt. Für Prägeformen gilt dies analog, da die typischen Auflösungen von Prägebildern vergleichbare Werte annehmen.

In einer bevorzugten Ausführungsform des erfindungsgemäßen Verfahrens weisen die erzeugten Schichten unterschiedliche Schichtdicken auf. Beispielweise können tieferliegende Schichten der Fotopolymerplatte mit einer größeren Dicke erzeugt werden als höherliegende Schichten. Durch die Verwendung größerer Schichtdicken kann eine Zeitersparnis erreicht werden, da eine größere Menge an Fotopolymer gleichzeitig gehärtet werden kann. Umgekehrt kann durch die Verwendung kleinerer Schichtdicken eine höhere Präzision bei der Herstellung der Strukturen der Fotopolymerplatte erreicht werden.

In einer bevorzugten Ausführungsform des erfindungsgemäßen Verfahrens weist ein gehärteter Bereich einer später erzeugten Schicht einen Versatz gegenüber einem gehärteten Bereich einer zuvor erzeugten Schicht auf, wobei der gehärtete Bereich der später erzeugten Schicht und der gehärtete Bereich der zuvor erzeugten Schicht miteinander verbunden sind. Insbesondere können auch mehrere gehärtete Bereiche einer später erzeugten Schicht einen Versatz gegenüber entsprechenden gehärteten Bereichen einer zuvor erzeugten Schicht aufweisen. Ferner können auch mehrere gehärtete Bereiche mehrerer Schichten sukzessive einen Versatz zueinander aufweisen. Durch Versätze der gehärteten Bereiche unterschiedlicher Schichten kann allgemein die Flexibilität bei der Herstellung der Strukturen einer Fotopolymerplatte gegenüber dem eingangs beschriebenen Verfahren des Stands der Technik erhöht werden. Beispielsweise können auf diese Art diagonal verlaufende Strukturen, welche sich über mindestens zwei Schichten der Fotopolymerplatte erstrecken, hergestellt werden. Durch die Herstellung diagonal verlaufender Strukturen können wiederum sogenannte Kompressionselemente erzeugt und in die Fotopolymerplatte integriert werden. Unter einem Kompressionselement wird im Zusammenhang mit der vorliegenden Erfindung eine tieferliegende, d.h. nicht druckende Struktur einer Fotopolymerplatte verstanden, welche den mechanischen Druck bei einem Druckvorgang oder einem Prägevorgang aufnehmen und in Verformungsenergie, beispielsweise zur Verformung der diagonal verlaufenden Strukturen, umwandeln kann. Kompressionselemente führen insbesondere beim Drucken auf unebenen oder flexiblen Materialien, wie beispielsweise Wellpappe, zu einem besseren Druckergebnis. Bislang werden zur Aufnahme des mechanischen Drucks üblicherweise separate Kompressionsschichten, beispielsweise flexible Klebefolien, zwischen den Druckzylinder und die Druckform eingebracht. Diese Maßnahme kann entfallen, wenn Kompressionselemente bei der Herstellung einer Fotopolymerplatte mit dem erfindungsgemäßen Verfahren direkt in die Fotopolymerplatte integriert werden können.

In einer bevorzugten Ausführungsform des erfindungsgemäßen Verfahrens weist ein gehärteter Bereich einer später erzeugten Schicht eine größere Querschnittsfläche auf als ein gehärteter Bereich einer zuvor erzeugten Schicht, wobei der gehärtete Bereich der später erzeugten Schicht und der gehärtete Bereich der zuvor erzeugten Schicht miteinander verbunden sind. Auch hierdurch kann allgemein die Flexibilität bei der Herstellung der Strukturen einer Fotopolymerplatte gegenüber dem eingangs beschriebenen Verfahren des Stands der Technik erhöht werden. Ein gehärteter Bereich einer später erzeugten Schicht, der eine größere Querschnittsfläche aufweist als ein gehärteter Bereich einer zuvor erzeugten Schicht, kann beispielsweise ebenfalls zur Erzeugung von Kompressionselementen verwendet werden.

In einer bevorzugten Ausführungsform des erfindungsgemäßen Verfahrens weist ein gehärteter Bereich einer später erzeugten Schicht eine kleinere Querschnittsfläche auf als ein gehärteter Bereich einer zuvor erzeugten Schicht, wobei der gehärtete Bereich der später erzeugten Schicht und der gehärtete Bereich der zuvor erzeugten Schicht miteinander verbunden sind. Auch hierdurch kann allgemein die Flexibilität bei der Herstellung der Strukturen einer Fotopolymerplatte gegenüber dem eingangs beschriebenen Verfahren des Stands der Technik erhöht werden. Ein gehärteter Bereich einer später erzeugten Schicht, der eine kleinere Querschnittsfläche aufweist als ein gehärteter Bereich einer zuvor erzeugten Schicht, kann beispielsweise ebenfalls zur Erzeugung von Kompressionselementen verwendet werden. Darüber hinaus können auf diese Weise jedoch auch sogenannte Mikropunkte hergestellt werden. Unter einem Mikropunkt wird im Zusammenhang mit der vorliegenden Erfindung eine Struktur verstanden, welche auf einer druckenden Oberfläche einer Flexodruckform angeordnet ist und eine kleinere Querschnittsfläche als die druckende Oberfläche aufweist. Mikropunkte werden in der Drucktechnik beispielsweise zum gezielten Einstellen einer Oberflächenbeschaffenheit einer druckenden Oberfläche verwendet. So kann zum Beispiel eine Mikrostruktur in Form einer Sandstruktur der Oberfläche erzeugt werden. Allgemein kann durch Mikropunkte unter anderem die Farbüberlagerung im resultierenden Druckbild verbessert werden. Die Definition eines Mikropunktes lässt sich analog auch auf Prägeformen übertragen. Dort können ebenfalls Mikrostrukturen der prägenden Oberflächen erzeugt werden.

In einer bevorzugten Ausführungsform des erfindungsgemäßen Verfahrens umfasst das Verfahren ferner mindestens einen der folgenden Schritte:
- Auswaschen und/oder Ausblasen des flüssigen Fotopolymers aus mindestens einem nicht gehärteten Bereich mindestens einer erzeugten Schicht;
- Trocknen mindestens eines gehärteten Bereichs mindestens einer erzeugten Schicht;
- Nachbelichten mindestens eines gehärteten Bereichs mindestens einer erzeugten Schicht.

Durch das Auswaschen und/oder Ausblasen kann überschüssiges flüssiges Fotopolymer, welches sich nach dem Erzeugen und selektiven Belichten der letzten hergestellten Schicht noch auf der Fotopolymerplatte befindet, entfernt werden. Das Auswaschen kann beispielsweise mit einem hierzu geeigneten Auswaschmittel, beispielsweise einer Waschlösung, erfolgen. Das Ausblasen kann beispielsweise mit Druckluft erfolgen. Durch das Trocknen können Rückstände des Auswaschmittels entfernt werden. Durch das Nachbelichten kann die Härte des gehärteten Fotopolymer weiter erhöht werden. Insbesondere kann dabei eine maximal mögliche Härte erreicht werden. Eine solche Erhöhung der Härte des Fotopolymers kann erforderlich sein, damit die Fotopolymerplatte beispielsweise den mechanischen Beanspruchungen beim Flexodruck beim Prägen standhält.

In einer bevorzugten Ausführungsform des erfindungsgemäßen Verfahrens wird als Fotopolymerplatte eine Flexodruckform oder eine Prägeform hergestellt. Eine solche Flexodruckform oder Prägeform kann gerasterte Bereiche aufweisen. Hierunter werden Bereiche der Oberfläche der Flexodruckform oder Prägeform verstanden, in denen das zu erzielende Druckbild oder Prägebild aus einzelnen Rasterpunkten zusammengesetzt ist. Jeder Rasterpunkt entspricht beispielsweise einer zylinderförmigen Struktur der Flexodruckform oder Prägeform. Die zylinderförmigen Strukturen können kegelförmige Sockel aufweisen, wodurch ihre Stabilität verbessert werden kann. Die Auflösung des Rasters kann beispielsweise zwischen 46 L/cm und 70 L/cm liegen, jedoch auch höhere Werte annehmen. Aufgrund des geringeren apparativen sowie zeitlichen Aufwands des erfindungsgemäßen Verfahrens können entsprechende Flexodruckformen oder Prägeformen kostengünstiger und schneller als bisher hergestellt werden.

Gemäß einer zweiten Lehre der vorliegenden Erfindung wird die oben genannte Aufgabe für eine Vorrichtung zur Herstellung einer Fotopolymerplatte dadurch gelöst, dass die Vorrichtung umfasst:
- ein Gefäß mit einem zumindest teilweise transparenten Begrenzungselement;
- eine Belichtungseinrichtung, welche dazu eingerichtet ist, eine Oberfläche des zumindest teilweise transparenten Begrenzungselements von außen selektiv zu belichten;
- eine bewegliche Halteeinrichtung, welche dazu eingerichtet ist, eine vollflächige Trägerschicht der Fotopolymerplatte zu halten und so zu bewegen, dass sich der Abstand zwischen der Trägerschicht und dem zumindest teilweise transparenten Begrenzungselement vergrößert.

Insbesondere handelt es sich bei der erfindungsgemäßen Vorrichtung um eine Vorrichtung zur Durchführung eines Verfahrens gemäß der ersten Lehre der Erfindung. Durch die beschriebene Ausgestaltung der Vorrichtung kann das erfindungsgemäße Verfahren auf besonders effiziente und vorteilhafte Weise durchgeführt werden. Bezüglich weiterer Details wird auf die Ausführungen im Zusammenhang mit der ersten Lehre verwiesen.

In einer bevorzugten Ausführungsform der erfindungsgemäßen Vorrichtung ist die bewegliche Halteeinrichtung dazu eingerichtet, die vollflächige Trägerschicht der Fotopolymerplatte entgegen der Schwerkraft zu bewegen. Hierzu wird ebenfalls auf die Ausführungen im Zusammenhang mit der ersten Lehre verwiesen.

In einer bevorzugten Ausführungsform der erfindungsgemäßen Vorrichtung umfasst die Belichtungseinrichtung mindestens eine LED, mindestens einen Laser oder mindestens eine Laserdiode als Lichtquelle. Hierzu wird ebenfalls auf die Ausführungen im Zusammenhang mit der ersten Lehre verwiesen.

In einer bevorzugten Ausführungsform der erfindungsgemäßen Vorrichtung umfasst die Belichtungseinrichtung einen Flächenlichtmodulator oder einen Flüssigkristallbildschirm. Hierzu wird ebenfalls auf die Ausführungen im Zusammenhang mit der ersten Lehre verwiesen.

Die erfindungsgemäße Vorrichtung kann ferner mindestens eines der folgenden Mittel umfassen:
- Mittel zum Auswaschen und/oder Ausblasen eines flüssigen Fotopolymers;
- Mittel zum Trocknen von gehärtetem Fotopolymer;
- Mittel zum Nachbelichten von gehärtetem Fotopolymer.

Alternativ können die genannten Mittel jedoch auch von einer oder mehreren separaten Vorrichtungen umfasst sein. Bezüglich der technischen Wirkungen wird auf die Ausführungen im Zusammenhang mit der ersten Lehre verwiesen.

In einer bevorzugten Ausführungsform der erfindungsgemäßen Vorrichtung ist die Vorrichtung dazu eingerichtet, eine Fotopolymerplatte in Form einer Flexodruckform oder einer Prägeform herzustellen. Hierzu wird ebenfalls auf die Ausführungen im Zusammenhang mit der ersten Lehre verwiesen.

Gemäß einer dritten Lehre der vorliegenden Erfindung wird die oben genannte Aufgabe für ein Computerprogrammprodukt dadurch gelöst, dass das Computerprogrammprodukt Befehle umfasst, die bei der Ausführung des Programms durch einen Prozessor eine Vorrichtung gemäß der zweiten Lehre der Erfindung dazu veranlassen, ein Verfahren gemäß der ersten Lehre der Erfindung auszuführen. Bezüglich weiterer Details wird auf die Ausführungen im Zusammenhang mit der ersten Lehre verwiesen.

Weitere Ausgestaltungen und Vorteile der Erfindung sind der folgenden detaillierten Beschreibung einiger beispielhafter Ausführungsformen der vorliegenden Erfindung, insbesondere in Verbindung mit der Zeichnung, zu entnehmen. Die Zeichnung zeigt in
- Fig. 1: ein schematisches Flussdiagramm einer beispielhaften Ausführungsform eines Verfahrens gemäß der ersten Lehre der Erfindung,
- Fig. 2: eine schematische Schnittansicht einer beispielhaften Ausführungsform einer Vorrichtung gemäß der zweiten Lehre der Erfindung,
- Fig. 3: eine schematische Schnittansicht einer weiteren beispielhaften Ausführungsform einer Vorrichtung gemäß der zweiten Lehre der Erfindung,
- Fig. 4a bis 4f: die Durchführung einer beispielhaften Ausführungsform eines Verfahrens gemäß der ersten Lehre der Erfindung mittels einer beispielhaften Ausführungsform einer Vorrichtung gemäß der zweiten Lehre der Erfindung, und
- Fig. 5: eine schematische Darstellung einer mit dem erfindungsgemäßen Verfahren hergestellten Fotopolymerplatte in Form einer Flexodruckform.

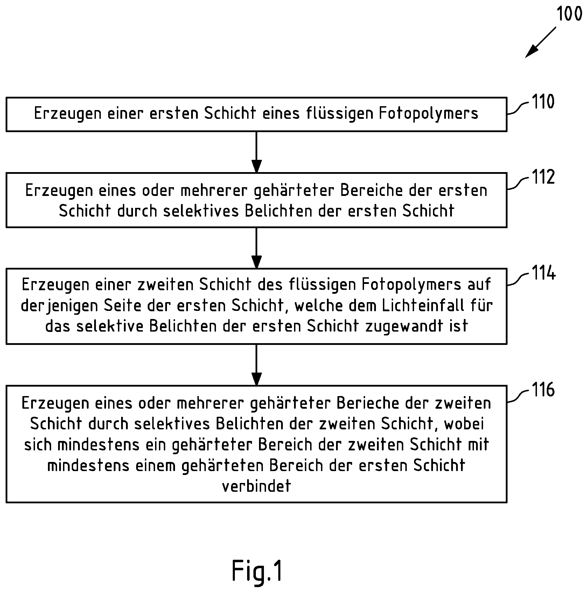

Das erfindungsgemäße Verfahren wird im Folgenden anhand von Fig. 1 beispielhaft beschrieben. Fig. 1 zeigt ein schematisches Flussdiagramm einer beispielhaften Ausführungsform des erfindungsgemäßen Verfahrens.

In dieser Ausführungsform umfasst das Verfahren 100 ein Erzeugen 110 einer ersten Schicht eines flüssigen Fotopolymers. Weiterhin umfasst das Verfahren ein Erzeugen 112 eines oder mehrerer gehärteter Bereiche der ersten Schicht durch selektives Belichten der ersten Schicht. Ferner umfasst das Verfahren ein Erzeugen 114 einer zweiten Schicht des flüssigen Fotopolymers auf derjenigen Seite der ersten Schicht, welche dem Lichteinfall für das selektive Belichten der ersten Schicht zugewandt ist. Schließlich umfasst das Verfahren ein Erzeugen 116 eines oder mehrerer gehärteter Bereiche der zweiten Schicht durch selektives Belichten der zweiten Schicht, wobei sich mindestens ein gehärteter Bereich der zweiten Schicht mit mindestens einem gehärteten Bereich der ersten Schicht verbindet.

Obwohl die einzelnen Verfahrensschritte in Fig. 1 in einer bestimmten Reihenfolge dargestellt sind, ist jede für den Fachmann sinnvolle Art und Weise, das Verfahren 100 auszuführen, denkbar, auch wenn sich dabei eine andere Reihenfolge oder gar keine Reihenfolge, d.h. eine simultane Ausführung einzelner oder aller Verfahrensschritte, ergibt.

Bei dem in Fig. 1 dargestellten Verfahren 100 ist die Herstellung einer Negativmaske durch Abtragen einer opaken Schicht nicht erforderlich, sodass der apparative Aufwand hierfür entfällt und außerdem die Gesamtzeit für die Herstellung einer Fotopolymerplatte reduziert werden kann. Zudem werden die Möglichkeiten hinsichtlich der herzustellenden Strukturen einer Flexodruckform oder einer Prägeform erweitert. Beispielsweise können Strukturen hergestellt werden, deren Querschnitt sich in Richtung der Rückseite der Fotopolymerplatte nicht vergrößert. Ferner können Strukturen unterschiedlicher Höhe (z.B. ein "undercut") auf besonders einfache Weise hergestellt werden.

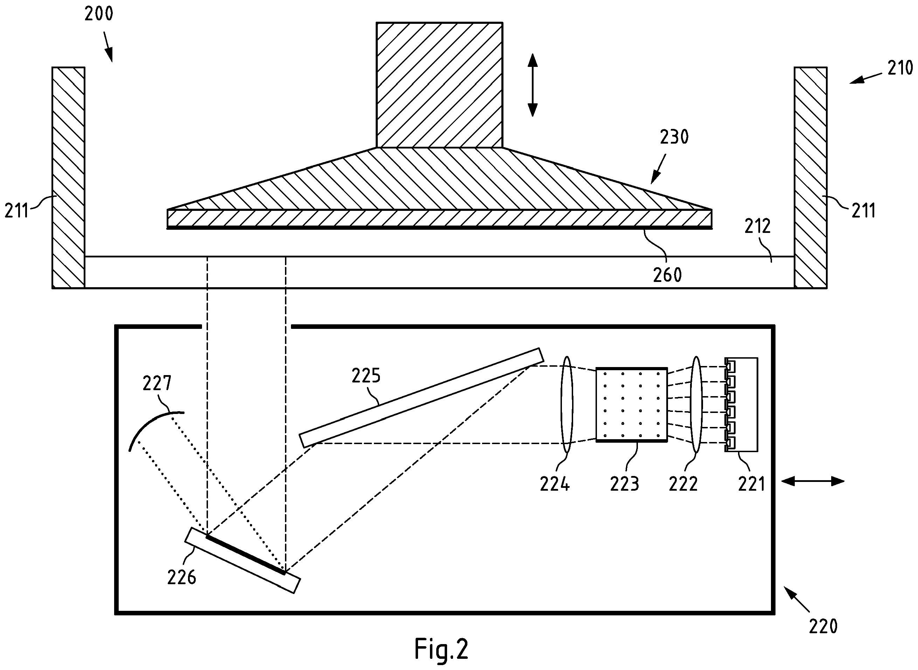

Fig. 2 zeigt eine beispielhafte Ausführungsform einer erfindungsgemäßen Vorrichtung in einer schematischen Schnittansicht. Die Vorrichtung 200 umfasst ein Gefäß 210 mit einer unterseitigen transparenten Platte 212 als Beispiel für ein zumindest teilweise transparentes Begrenzungselement. Die transparente Platte 212 ist für Wellenlängen aus dem UV-VIS-Bereich lichtdurchlässig. Sie ist umfangsseitig gegenüber den Wänden 211 des Gefäßes 210 abgedichtet.

Des weiteren umfasst die Vorrichtung 200 in dieser Ausführungsform eine Belichtungseinrichtung 220 mit einem Flächenlichtmodulator 226 in Form eines DMD-Chips 226. Die Belichtungseinrichtung 220 weist als Lichtquelle 221 beispielhaft ein Laserdioden-Array 221 auf. Das Laserdioden-Array 221 besteht hier beispielhaft aus 36 parallel ausgerichteten Laserdioden, welche in sechs Zeilen mit je sechs Laserdioden angeordnet sind und UV-Licht emittieren. Das von dem Laserdioden-Array 221 ausgehende Licht wird mittels einer Linse 222 auf einen Diffusor 223 gerichtet und dort durch Streuung homogenisiert, sodass aus dem Diffusor 223 ein Lichtstrahlbündel mit einer nahezu konstanten räumlichen Lichtintensität austritt. Dieses Lichtstrahlbündel wird über eine weitere Linse 224 auf einen Spiegel 225 gerichtet und von diesem auf den DMD-Chip 226 reflektiert. Der DMD-Chip weist matrixförmig angeordnete Mikrospiegel auf, die durch elektronische Ansteuerung zwischen zwei stabilen Endzuständen verkippbar sind. Diejenigen Mikrospiegel, die sich in einer ersten Kippposition befinden, reflektieren jeweils kleine Ausschnitte des Lichtstrahlbündels in die Projektionsrichtung, welche in Fig. 2 senkrecht nach oben verläuft. Diejenigen Mikrospiegel, die sich in einer zweiten Kippposition befinden, reflektieren jeweils andere Ausschnitte des Lichtstrahlbündels aus der Projektionsrichtung heraus. Die entsprechend reflektierten Ausschnitte treffen auf einen Absorber 227, welcher die Lichtstrahlen absorbiert. Das senkrecht nach oben projizierte Lichtbündel tritt schließlich aus der Belichtungseinrichtung 220 aus und trifft von unten auf die untere Oberfläche der transparenten Platte 212 des Gefäßes 210. Die Lichtstrahlen des Lichtbündels können somit die transparente Platte 212 durchdringen und eine Schicht eines flüssigen Fotopolymers, welches in das Gefäß 210 eingebracht werden kann, selektiv belichten. Ein exemplarischer Strahlengang ausgehend von dem Laserdioden-Array 221 bis zur inneren Oberfläche der transparenten Platte 212 ist in Fig. 2 durch gestrichelte Linien angedeutet. Grundsätzlich besteht eine Vielzahl von Möglichkeiten, die Belichtungseinrichtung 220 auszugestalten und die hier soeben beschriebene Variante soll in keiner Weise einschränkend verstanden werden. Eine Gemeinsamkeit der denkbaren Varianten besteht lediglich darin, dass sie mindestens eine Lichtquelle sowie mindestens einen Flächenlichtmodulator aufweisen.

Ferner umfasst die Vorrichtung 200 eine Halteeinrichtung 230. Die Halteeinrichtung 230 ist senkrecht bewegbar, wie durch den senkrechten Pfeil in Fig. 2 angedeutet. Sie weist auf ihrer Unterseite eine rechteckige Fläche auf und ist dazu eingerichtet, eine vollflächige Trägerschicht 260 für eine Fotopolymerplatte zu halten und gemeinsam mit ihr zu bewegen. Insbesondere ist die Halteeinrichtung 230 dazu eingerichtet, die Trägerschicht 260 nach oben, also entgegen der Schwerkraft, zu bewegen, sodass sich der Abstand zwischen der Trägerschicht 260 und der transparenten Platte 212 vergrößert. Bei der Trägerschicht 260 handelt es sich hier beispielhaft um eine Polymerfolie 260. Zum Halten der Trägerschicht 260 weist die Halteeinrichtung 230 auf ihrer Unterseite eine Vielzahl von Löchern (nicht dargestellt) auf, welche mit einer Saugvorrichtung (nicht dargestellt) verbunden und mit Unterdruck beaufschlagt sind. Somit hält die Halteeinrichtung 230 die Trägerschicht 260 unter Verwendung eines Funktionsprinzips, welches im Wesentlichen einem auf den Kopf gestellten Vakuumtisch entspricht. Die vertikale Bewegung der Halteeinrichtung 230, welche durch den vertikalen Pfeil in Fig. 2 angedeutet ist, erfolgt durch entsprechende Antriebsmittel (nicht dargestellt).

Nachdem in der in Fig. 2 dargestellten beispielhaften Ausführungsform die Fläche des Lichtstrahlbündels, welches von dem DMD-Chip 226 senkrecht nach oben projiziert wird, kleiner ist als die Fläche der Trägerschicht 260, muss die Belichtungseinrichtung 220 die jeweils zu belichtende Gesamtfläche zeilenweise abfahren. Zu diesem Zweck ist die Belichtungseinrichtung 220 durch entsprechende Antriebsmittel (nicht dargestellt) horizontal in der durch die transparente Platte 212 definierte Ebene beweglich, wie durch den horizontalen Pfeil in Fig. 2 angedeutet. Alternativ wäre es jedoch auch denkbar, das von dem DMD-Chip 226 senkrecht nach oben projizierte Lichtstrahlbündel durch geeignete und dem Fachmann bekannte Maßnahmen aufzuweiten, sodass hierdurch die gesamte Fläche der Trägerschicht 260 gleichzeitig belichtet werden kann. In diesem Fall ist es nicht erforderlich, dass die Belichtungseinrichtung 220 die jeweils zu belichtende Gesamtfläche zeilenweise abfährt und die Antriebmittel (nicht dargestellt) können entfallen. Zudem kann die insgesamt notwendige Zeit für das selektive Belichten reduziert werden. Alternativ können auch mehrere gleichartige Belichtungseinrichtungen 220 nebeneinander verwendet werden, deren senkrecht nach oben projizierte Lichtstrahlbündel optional aufgeweitet werden, um die gesamte Fläche der Trägerschicht 260 gleichzeitig zu belichten.

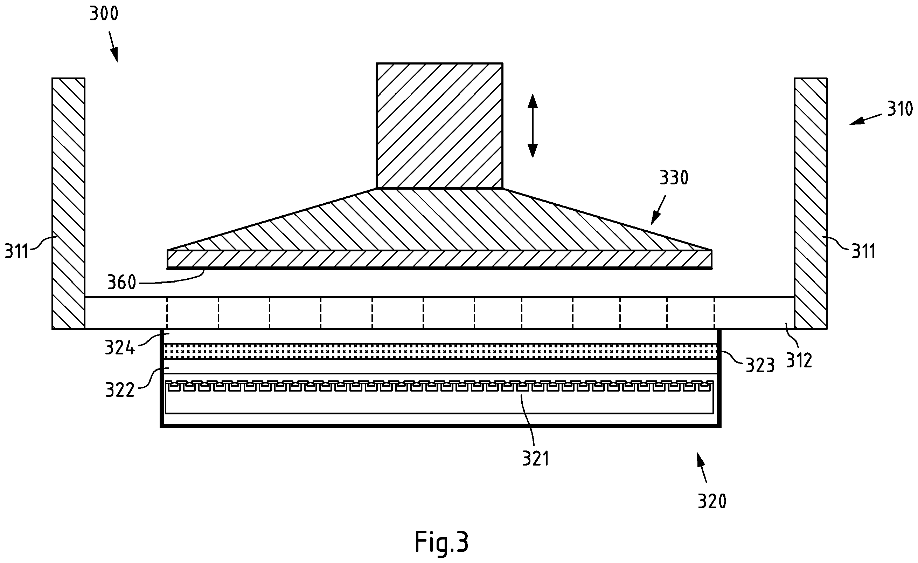

Fig. 3 zeigt eine weitere Ausführungsform einer erfindungsgemäßen Vorrichtung in einer schematischen Schnittansicht. Die Vorrichtung 300 umfasst ebenfalls ein Gefäß 310 mit einer unterseitigen transparenten Platte 312, welche für Wellenlängen aus dem UV-VIS-Bereich lichtdurchlässig ist und umfangsseitig gegenüber den Wänden 311 des Gefäßes 310 abgedichtet ist. Außerdem umfasst die Vorrichtung 300 auch eine senkrecht bewegbare Halteeinrichtung 330, welche auf ihrer Unterseite eine rechteckige Fläche aufweist und dazu eingerichtet ist, eine vollflächige Trägerschicht 360 für eine Fotopolymerplatte zu halten und gemeinsam mit ihr zu bewegen. Diesbezüglich gelten die obigen Ausführungen, die in Zusammenhang mit Fig. 2 für die Halteeinrichtung 230 gemacht wurden, in gleicher Weise auch für die Halteeinrichtung 330 der in Fig. 3 dargestellten Ausführungsform.

Anders als in Fig. 2 weist die Vorrichtung 300 jedoch als Belichtungseinrichtung 320 einen Flüssigkristallbildschirm 320 auf. Dieser ist in eine Vielzahl von Pixeln unterteilt, welche eine quadratische Form aufweisen, matrixförmig angeordnet sind und unabhängig voneinander ihre Transparenz ändern können. Die Unterteilung in die einzelnen Pixel ist in Fig. 3 jedoch aus Gründen der besseren Übersicht nicht dargestellt. Jedes Pixel ist sandwichartig aufgebaut und umfasst hier beispielsweise eine rückseitige Lichtquelle 321, eine erste transparente Platte 322, eine Flüssigkristallschicht 323 und eine zweite transparente Platte 324. Bei der Lichtquelle handelt es sich hier beispielsweise um ein LED-Array 321, wobei jede einzelne LED des Arrays eine rückseitige Lichtquelle eines jeweiligen Pixels bildet und UV-Licht emittiert. Die erste transparente Platte 322 ist auf ihrer nach unten zeigenden Oberfläche, d.h. auf der Oberfläche, die dem LED-Array zugewandt ist, mit einem ersten Polarisationsfilter (nicht dargestellt) beschichtet. Außerdem ist die zweite transparente Platte 324 auf ihrer nach oben zeigenden Oberfläche, d.h. auf der Oberfläche, die dem LED-Array abgewandt ist, mit einem zweiten Polarisationsfilter (nicht dargestellt) beschichtet. Zur Änderung der Transparenz eines Pixels wird mittels elektrischer Spannung die Ausrichtung der Flüssigkristalle in der Flüssigkristallschicht 323 gesteuert. In Abhängigkeit der Polarisationsrichtungen der beiden Polarisationsfilter und in Abhängig der Ausrichtung der Flüssigkristalle wird das Pixel damit entweder durchlässig oder undurchlässig für das von der rückseitigen Lichtquelle 321 ausgesandte UV-Licht. Die von einem transparenten Pixel ausgehenden und senkrecht nach oben verlaufenden Lichtstrahlen treffen von unten auf die untere Oberfläche der transparenten Platte 312 des Gefäßes 310. Die Lichtstrahlen können somit die transparente Platte 312 durchdringen und eine Schicht eines flüssigen Fotopolymers, welches in das Gefäß 310 eingebracht werden kann, selektiv belichten. Exemplarische Lichtstrahlen einer solchen Belichtung sind in Fig. 3 durch gestrichelte Linien angedeutet.

Nachdem in der in Fig. 3 dargestellten beispielhaften Ausführungsform die Fläche des Lichtstrahlbündels, welches von dem Flüssigkristallbildschirm 320 nach oben ausgesandt wird, gleich groß oder geringfügig größer ist als die Fläche der Trägerschicht 360, kann die gesamte Fläche der Trägerschicht 360 gleichzeitig belichtet werden. Alternativ wäre es jedoch auch denkbar, dass der Flüssigkristallbildschirm 320 kleiner dimensioniert wird und die jeweils zu belichtende Gesamtfläche zeilenweise abfährt. Zu diesem Zweck kann der Flüssigkristallbildschirm 320 durch entsprechende Antriebsmittel (nicht dargestellt) horizontal in der durch die transparente Platte 312 definierte Ebene beweglich sein. Das gleichzeitige Belichten der gesamten Fläche der Trägerschicht 360, wie in Fig. 3 dargestellt, bringt jedoch den Vorteil mit sich, dass die insgesamt notwendige Zeit für das selektive Belichten reduziert werden kann. Als weitere Alternative können auch mehrere Flüssigkristallbildschirme 320 nebeneinander verwendet werden, um die gesamte Fläche der Trägerschicht 360 gleichzeitig zu belichten.

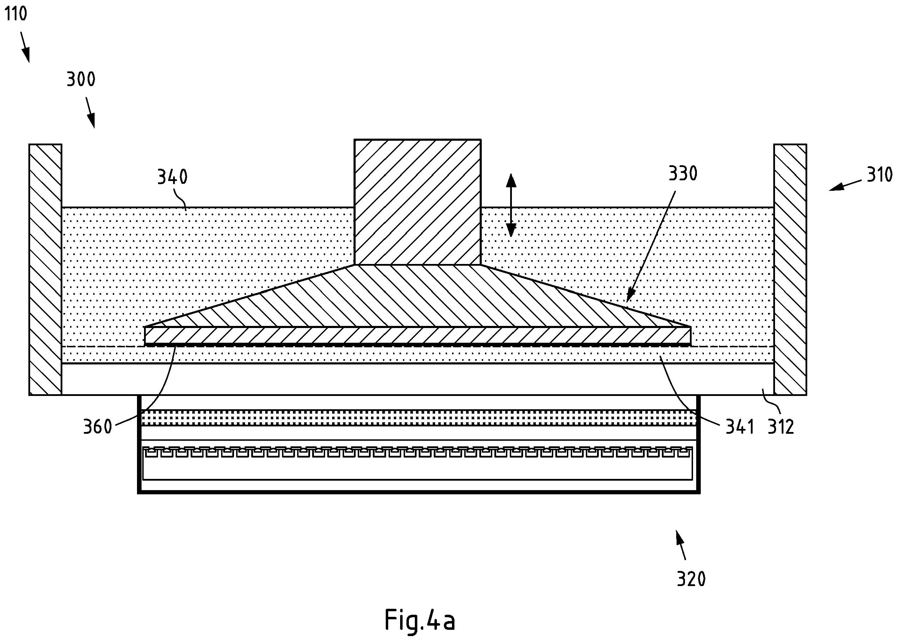

Die Figuren 4a bis 4e zeigen die Durchführung einer Ausführungsform eines erfindungsgemäßen Verfahrens mittels einer Ausführungsform einer erfindungsgemäßen Vorrichtung. Die Durchführung des Verfahrens wird dabei anhand der Vorrichtung 300, die bereits in Zusammenhang mit Fig. 3 beschrieben wurde, gezeigt. Dies ist jedoch in keiner Weise als einschränkend aufzufassen und ebenso kann ein erfindungsgemäßes Verfahren beispielsweise auch mit der Vorrichtung 200, welche in Zusammenhang mit Fig. 2 beschrieben wurde, oder mit einer anderen Ausführungsform einer erfindungsgemäßen Vorrichtung durchgeführt werden.

Zunächst ist in Fig. 4a eine Situation gezeigt, in der flüssiges Fotopolymer 340 in das Gefäß 310 der Vorrichtung 300 eingefüllt wurde. Ferner wurde die Halteeinrichtung 330 vertikal so positioniert, dass ein Abstand zwischen der an der Halteeinrichtung 330 fixierten Trägerschicht 360 und der transparenten Platte 312 des Gefäßes 310 entsteht. Die in diesem Zusammenhang erfolgte Bewegung der Halteeinrichtung 330 ist durch den vertikalen Pfeil in Fig. 4a angedeutet. Durch den Abstand zwischen der transparenten Platte 312 und der Trägerschicht 360 der herzustellenden Fotopolymerplatte oberhalb der transparenten Platte 312 eine erste Schicht 341 des flüssigen Fotopolymers 340 erzeugt, was dem Schritt 110 der in Fig. 1 dargestellten Ausführungsform des erfindungsgemäßen Verfahrens entspricht. Die Trägerschicht 360 ist hier beispielhaft eine Polymerfolie 360. Alternativ kann die Trägerschicht jedoch auch dadurch hergestellt werden, dass noch vor dem Erzeugen der ersten Schicht 341 eine weitere Schicht aus flüssigem Fotopolymer zwischen der Unterseite der Halteeinrichtung 330 und der transparenten Platte 312 erzeugt und anschließend durch vollflächiges Belichten gehärtet wird.

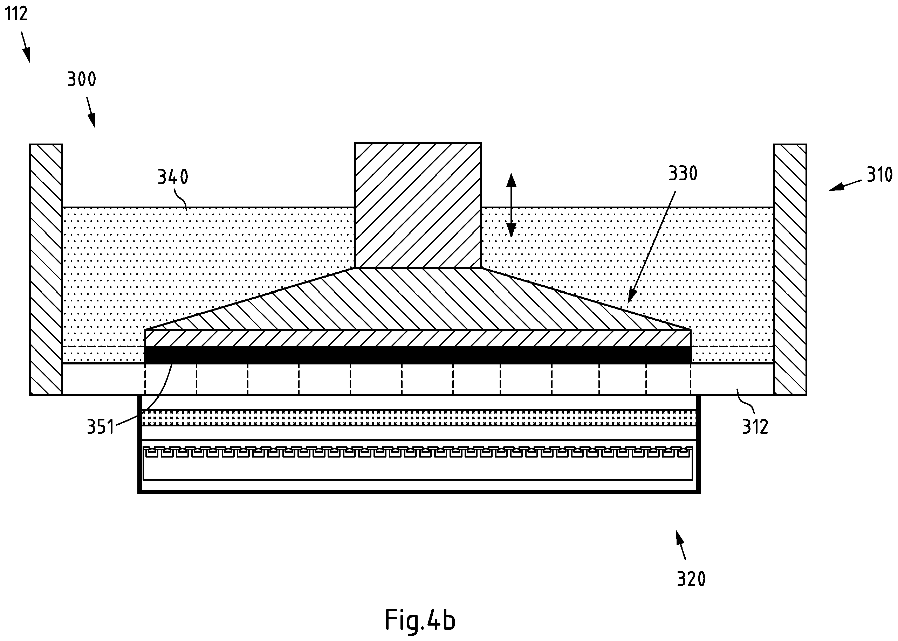

In Fig. 4b ist eine Situation gezeigt, in der die Halteeinrichtung 330 in ihrer Position verbleibt und die erste Schicht 341 des flüssigen Fotopolymers 340 unter Verwendung der Belichtungseinrichtung 320 durch die transparente Platte 312 hindurch von unten selektiv belichtet wird. Das hierzu von der Belichtungseinrichtung 320 ausgesandte Licht trifft dabei, bezogen auf das Gefäß 310, von außen auf die transparente Platte 312. Durch das selektive Belichten wird flüssiges Fotopolymer 340 der ersten Schicht gehärtet und ein gehärteter Bereich 351 wird erzeugt, was dem Schritt 112 der in Fig. 1 dargestellten Ausführungsform des erfindungsgemäßen Verfahrens entspricht. Der gehärtete Bereich 351 verbindet sich dabei mit der Trägerschicht 360. In dem hier beschriebenen Beispiel findet eine vollflächige Belichtung statt, wobei exemplarische Lichtstrahlen in Fig. 4b durch gestrichelte Linien angedeutet sind. Aufgrund der vollflächigen Belichtung wird ein zusammenhängender gehärteter Bereich 351 erzeugt, welcher sich in diesem Beispiel über die gesamte Oberfläche der Trägerschicht 360 erstreckt. Auf diese Weise wird ein Fundament aus gehärtetem Fotopolymer gebildet, mit dem sich zu einem späteren Zeitpunkt gebildete Strukturen der herzustellenden Fotopolymerplatte verbinden können.

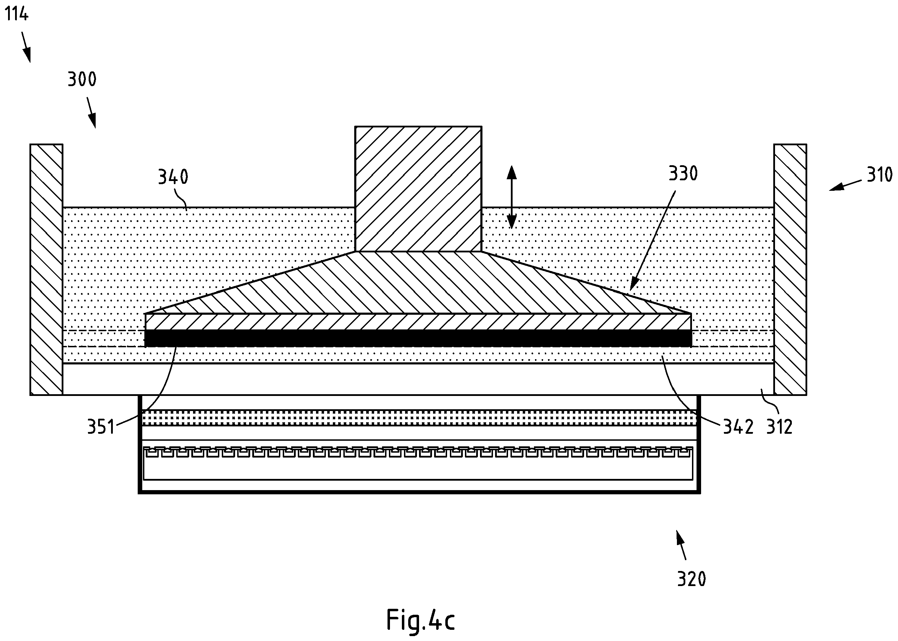

In der in Fig. 4c dargestellten Situation wurde nun das Belichten der ersten Schicht beendet und die Halteeinrichtung 330 wurde vertikal nach oben, d.h. entgegen der Schwerkraft, bewegt, wie durch den vertikalen Pfeil in Fig. 4c angedeutet. Die an der Halteeinrichtung 330 fixierte Trägerschicht 360 sowie der mit der Trägerschicht 360 verbundene gehärtete Bereich 351 wurden dementsprechend ebenfalls mit nach oben bewegt. Hierdurch vergrößert sich insbesondere der Abstand zwischen der Trägerschicht 360 und der transparenten Platte 312. Bei der Bewegung der Halteeinrichtung 330 löst sich der gehärtete Bereich 351 von der transparenten Platte 312 und es entsteht ein Volumen zwischen dem gehärteten Bereich 351 einerseits und der transparenten Platte 312 andererseits, welches dadurch aufgefüllt wird, dass flüssiges Fotopolymer aus einer seitlichen Richtung in das Volumen einströmt. Hierdurch wird oberhalb der transparenten Platte 312 eine zweite Schicht 342 des flüssigen Fotopolymers 340 erzeugt, entsprechend dem Schritt 114 der in Fig. 1 dargestellten Ausführungsform des erfindungsgemäßen Verfahrens. Wie aus Fig. 4c in Verbindung mit Fig. 4b ebenfalls ersichtlich ist, wird die zweite Schicht 342 auf derjenigen Seite der ersten Schicht erzeugt, welche dem Lichteinfall für das selektive Belichten der ersten Schicht 341 zugewandt ist.

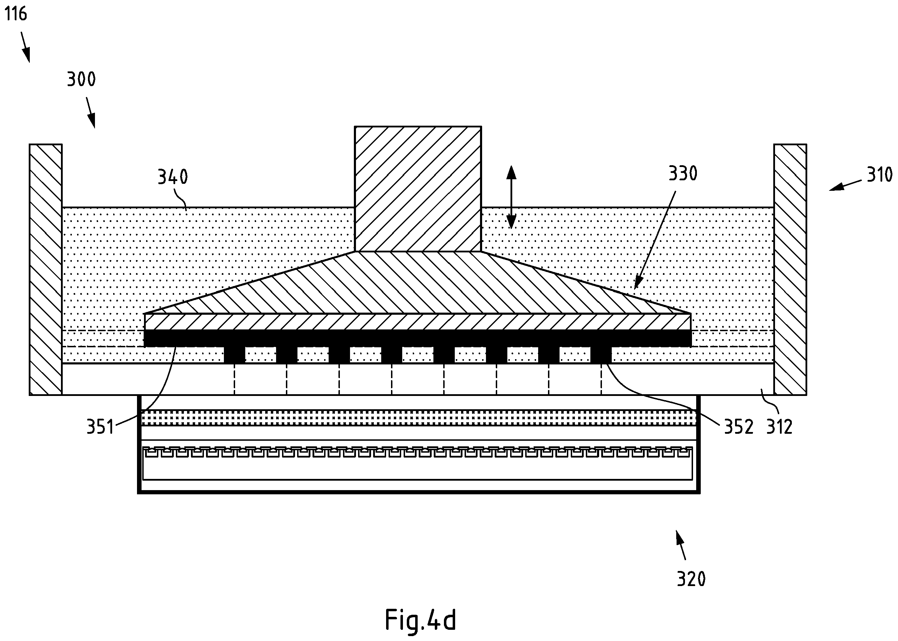

In der in Fig. 4d dargestellten Situation verbleibt die Halteeinrichtung 330 in ihrer Position und die zweite Schicht 342 des flüssigen Fotopolymers 340 wird unter Verwendung der Belichtungseinrichtung 320 durch die transparente Platte 312 hindurch von unten selektiv belichtet. Diese Situation ist größtenteils analog zu der in Fig. 4b dargestellten Situation, mit dem wesentlichen Unterschied, dass nun die zweite Schicht 342 anstelle der ersten Schicht 341 selektiv belichtet wird. Das hierzu von der Belichtungseinrichtung 320 ausgesandte Licht trifft erneut, bezogen auf das Gefäß 310, von außen auf die transparente Platte 312. Durch das selektive Belichten wird das flüssige Fotopolymer 340 der zweiten Schicht gehärtet und mehrere gehärtete Bereiche 352 werden erzeugt, was dem Schritt 116 der in Fig. 1 dargestellten Ausführungsform des erfindungsgemäßen Verfahrens entspricht. Die gehärteten Bereiche 352 verbinden sich dabei mit dem als Fundament dienenden gehärteten Bereich 351 der ersten Schicht. In dem hier beschriebenen Beispiel werden durch selektives Belichten insgesamt acht gehärtete Bereiche 352 erzeugt; die dazwischen und darum herum liegenden Bereiche der zweiten Schicht 342 werden durch eine entsprechende Ansteuerung der Belichtungseinrichtung 320 von der Belichtung ausgenommen, sodass dort keine Härtung des flüssigen Fotopolymers erfolgt. Exemplarische Lichtstrahlen der soeben beschriebenen selektiven Belichtung sind in Fig. 4d erneut durch gestrichelte Linien angedeutet.

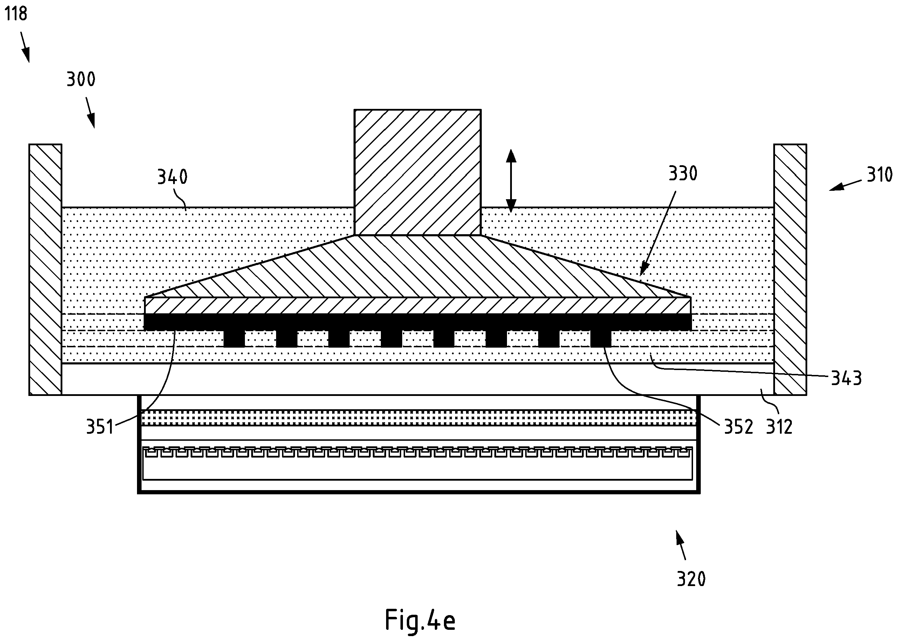

In der in Fig. 4e dargestellten Situation wurde das Belichten der zweiten Schicht beendet und die Halteeinrichtung 330 wurde erneut vertikal nach oben bewegt.

Dementsprechend wurden auch die an der Halteeinrichtung 330 fixierte Trägerschicht 360, der mit der Trägerschicht 360 verbundene gehärtete Bereich 351 der ersten Schicht, sowie die mit dem gehärteten Bereich 351 verbundenen acht gehärteten Bereiche 352 der zweiten Schicht mit nach oben bewegt. Wie bereits in Fig. 4c vergrößert sich auch hier der Abstand zwischen der Trägerschicht 360 und der transparenten Platte 312. Bei der Bewegung der Halteeinrichtung 330 lösen sich nun die gehärteten Bereiche 352 der zweiten Schicht von der transparenten Platte 312 und es entsteht ein Volumen zwischen den gehärteten Bereichen 352 und den im flüssigen Zustand verbliebenen Bereichen der zweiten Schicht 342 einerseits sowie der transparenten Platte 312 andererseits. Dieses Volumen wird ein weiteres Mal dadurch aufgefüllt, dass flüssiges Fotopolymer aus einer seitlichen Richtung in das Volumen einströmt. Hierdurch wird oberhalb der transparenten Platte 312 eine dritte Schicht 343 des flüssigen Fotopolymers 340 erzeugt, was hier als Schritt 118 bezeichnet ist. Wie aus Fig. 4e in Verbindung mit Fig. 4d ebenfalls ersichtlich ist, wird die dritte Schicht 343 auf derjenigen Seite der zweiten Schicht erzeugt, welche dem Lichteinfall für das selektive Belichten der zweiten Schicht 342 zugewandt ist.

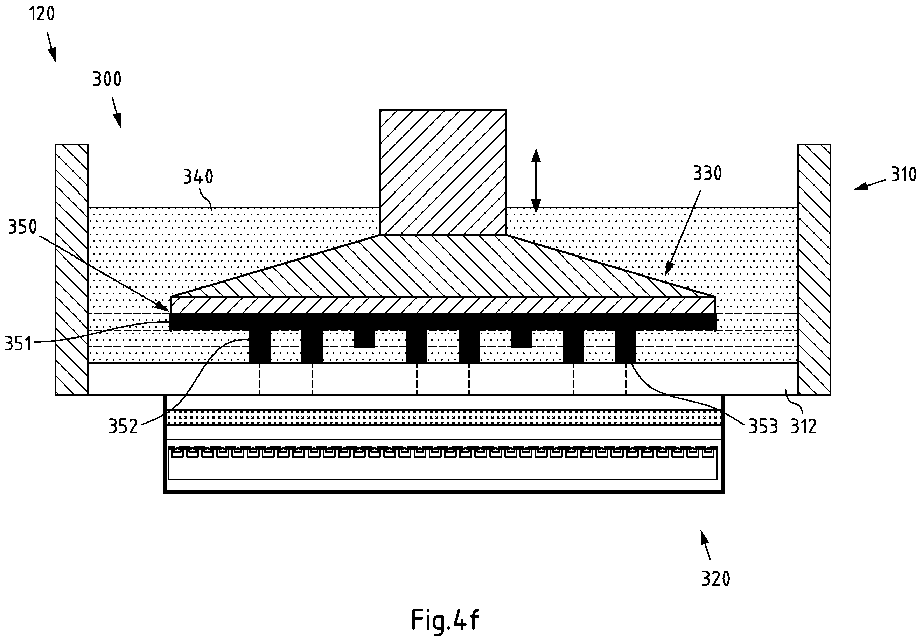

In der in Fig. 4f dargestellten Situation verbleibt die Halteeinrichtung 330 in ihrer Position und die dritte Schicht 343 des flüssigen Fotopolymers 340 wird unter Verwendung der Belichtungseinrichtung 320 durch die transparente Platte 312 hindurch von unten selektiv belichtet. Diese Situation ist größtenteils analog zu der in Fig. 4d dargestellten Situation, mit dem wesentlichen Unterschied, dass nun die dritte Schicht 343 anstelle der zweiten Schicht 342 selektiv belichtet wird. Das hierzu von der Belichtungseinrichtung 320 ausgesandte Licht trifft erneut, bezogen auf das Gefäß 310, von außen auf die transparente Platte 312. Durch das selektive Belichten wird das flüssige Fotopolymer 340 der dritten Schicht gehärtet und mehrere gehärtete Bereiche 353 werden erzeugt, was hier als Schritt 120 bezeichnet ist. Die gehärteten Bereiche 353 verbinden sich dabei mit entsprechenden gehärteten Bereichen 352 der zweiten Schicht. In dem hier beschriebenen Beispiel werden durch selektives Belichten insgesamt sechs gehärtete Bereiche 353 erzeugt; die dazwischen und darum herum liegenden Bereiche der dritten Schicht 343 werden erneut von der Belichtung ausgenommen, sodass dort keine Härtung des flüssigen Fotopolymers erfolgt.

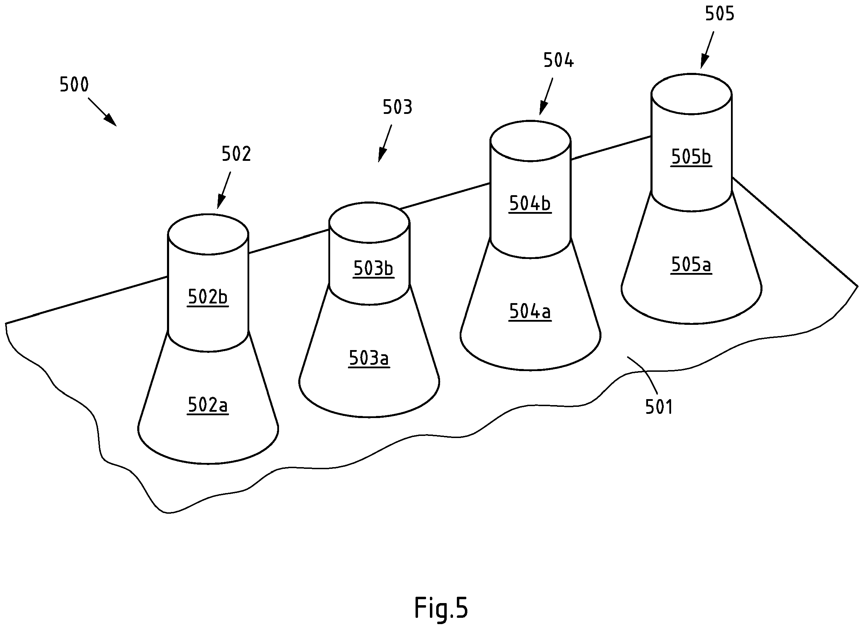

Durch wiederholtes Erzeugen weiterer Schichten des flüssigen Fotopolymers 340 und anschließendes selektives Belichten der erzeugten Schichten könnte nun prinzipiell noch eine Vielzahl weiterer Schichten mit gehärteten Bereichen hergestellt werden. In diesem Beispiel, welches lediglich der Veranschaulichung dient, werden jedoch keine weiteren Schichten mehr erzeugt und dementsprechend hat die resultierende Fotopolymerplatte 350 in Fig. 4f einen Aufbau aus drei Schichten. Dadurch, dass acht gehärtete Bereiche 352 der zweiten Schicht, jedoch nur sechs gehärtete Bereiche 353 der dritten Schicht erzeugt wurden, weist die Fotopolymerplatte 350 außerdem Strukturen unterschiedlicher Höhe auf. Dieser Aspekt wird nachfolgend in Zusammenhang mit Fig. 5 noch näher erläutert. Ferner weisen die gehärteten Bereiche der beiden als letztes erzeugten Schichten, d.h. sowohl die gehärteten Bereiche 352 der zweiten Schicht als auch die gehärteten Bereiche 353 der dritten Schicht, jeweils eine Querschnittsfläche von höchstens 0,049 mm², bevorzugt höchstens 0,029 mm², besonders bevorzugt höchstens 0,016 mm² auf. Hierdurch kann erreicht werden, dass die hergestellte Fotopolymerplatte 350, bei der es sich hier beispielhaft um eine Flexodruckform 350 handelt, die Anforderungen bezüglich der beim Druck zu erreichenden Auflösung erfüllt.

Schließlich wird die Fotopolymerplatte 350 noch ausgewaschen, getrocknet und nachbelichtet. Beim Auswaschen wird flüssiges Fotopolymer, welches sich nach dem Erzeugen und selektiven Belichten der dritten Schicht noch auf der Fotopolymerplatte befindet, entfernt. Anstelle des oder zusätzlich zum Auswaschen könnte auch ein Ausblasen des verbleibenden Fotopolymers mit Druckluft durchgeführt werden. Ferner werden beim Trocknen Rückstände des Auswaschmittels entfernt. Durch das Nachbelichten wird schließlich die Härte des gehärteten Fotopolymers in den gehärteten Bereichen 351, 352, 353 bis auf die maximale Härte, welche mit dem hier verwendeten Fotopolymer erreichbar ist, erhöht. Das Auswaschen, Trocknen und Nachbelichten findet hier exemplarisch in einer separaten Vorrichtung statt; ebenso könnte die Vorrichtung 300 jedoch auch entsprechende Mittel hierzu aufweisen. Ferner könnte die Vorrichtung 300 oder eine separate Vorrichtung beispielsweise eine Druckluftpistole zum Ausblasen des verbleibenden Fotopolymers aufweisen.

Fig. 5 zeigt eine schematische Darstellung einer beispielhaften Fotopolymerplatte 500 in Form einer Flexodruckform 500, welche mit dem erfindungsgemäßen Verfahren hergestellt wurde. Die nachfolgenden Ausführungen gelten jedoch weitestgehend analog auch für Prägeformen. Die Flexodruckform 500 weist ein Fundament 501 aus gehärtetem Fotopolymer auf. Außerdem sind in Fig. 5 beispielhaft vier Strukturen 502, 503, 504, 505 gezeigt, die ebenfalls aus gehärtetem Fotopolymer bestehen und mit dem Fundament 501 verbunden sind. Jede der vier Strukturen 502, 503, 504, 505 ist zweiteilig aufgebaut und umfasst je einen kegelförmigen Sockel 502a, 503a, 504, 505a sowie je einen zylinderförmigen Oberbau 502b, 503b, 504b, 505b. Die Strukturen 502, 503, 504, 505 wurden entsprechend dem erfindungsgemäßen Verfahren durch selektives Belichten einzelner Schichten aus flüssigem Fotopolymer hergestellt, wobei beispielhaft insgesamt 30 Schichten erzeugt wurden. Die Strukturen 502, 503, 504, 505 bilden einen Ausschnitt eines gerasterten Bereichs der Flexodruckform 500, in dem das zu erzielende Druckbild aus einzelnen Rasterpunkten zusammengesetzt ist. Die oberseitigen Flächen der zylinderförmigen Oberbauten 502b, 503b, 504b, 505b entsprechen dabei den Rasterpunkten des Druckbilds; die kegelförmigen Sockel 502a, 503a, 504, 505a dienen der Erhöhung der Stabilität der Strukturen 502, 503, 504, 505. Aufgrund des geringeren apparativen sowie zeitlichen Aufwands des erfindungsgemäßen Verfahrens können Flexodruckformen wie die dargestellte Flexodruckform 500 kostengünstiger und schneller als bisher hergestellt werden.

Daneben weisen die zylinderförmigen Oberbauten 502b, 503b, 504b, 505b der Strukturen 502, 503, 504, 505 die Besonderheit auf, dass sich ihr Querschnitt sich in Richtung der Rückseite der Fotopolymerplatte, d.h. in Richtung des Fundaments 501, nicht vergrößert. Im Gegensatz zu dem eingangs beschriebenen Verfahren des Stands der Technik können derartige Strukturen mit dem erfindungsgemäßen Verfahren hergestellt werden, da die Dicke des in einem Verfahrensschritt zu härtenden Fotopolymers aufgrund der Unterteilung in Schichten deutlich kleiner ist, sodass sich Streueffekte praktisch nicht auswirken. Strukturen, deren Querschnitt sich in Richtung der Rückseite der Fotopolymerplatte nicht vergrößert, haben den Vorteil, dass die Räume zwischen den Strukturen beim Drucken mehr Farbe aufnehmen können, sodass es nicht so häufig erforderlich ist, die Druckform zu reinigen.

Ferner weisen die Strukturen 502, 503, 504, 505 unterschiedliche Höhen auf; konkret ist die Höhe der Struktur 503 kleiner als die Höhe der übrigen Strukturen 502, 504, 505. Strukturen geringerer Höhe ("undercut") können beispielsweise im Flexodruck vorteilhaft sein, um insbesondere bei flächigen Druckelementen und vergleichsweise niedrigem Farbauftrag ein besseres Druckergebnis zu erzielen. Mit dem erfindungsgemäßen Verfahren können Strukturen geringerer Höhe, wie in diesem Beispiel die Struktur 503, auf einfache Weise dadurch hergestellt werden, dass der entsprechende Bereich bei mindestens einer als letztes erzeugten und selektiv belichteten Schicht von der Belichtung ausgenommen wird, sodass dort keine Härtung des Fotopolymers auftritt. Je größer die Anzahl der als letztes erzeugten und selektiv belichteten Schichten ist, bei denen der entsprechende Bereich von der Belichtung ausgenommen wird, umso geringer fällt die resultierende Höhe der Struktur aus.

Die zylinderförmigen Oberbauten 502b, 503b, 504b, 505b der Strukturen 502, 503, 504, 505 haben außerdem jeweils eine Querschnittsfläche von 0,008 mm². Aufgrund ihres kreisförmigen Querschnitts entspricht dies einem Durchmesser von 0,1 mm. In diesem Beispiel ergibt sich daraus eine Auflösung des Druckbilds von 50 L/cm, was dadurch begründet ist, dass die zylinderförmigen Oberbauten 502b, 503b, 504b, 505b nicht direkt benachbart sind, sondern einen Abstand zueinander aufweisen, der ihrem Durchmesser entspricht (in Fig. 5 nicht exakt maßstabsgetreu dargestellt). Wären die zylinderförmigen Oberbauten 502b, 503b, 504b, 505b direkt benachbart, läge die Auflösung des Druckbilds in diesem Beispiel bei 100 L/cm. Durch die angegebene Querschnittsfläche der zylinderförmigen Oberbauten 502b, 503b, 504b, 505b kann sichergestellt werden, dass eine durch das erfindungsgemäße Verfahren hergestellte Flexodruckform die Anforderungen bezüglich der beim Druck zu erreichenden Auflösung erfüllt.

Abschließend ist noch zu erwähnen, dass die Strukturen 502, 503, 504, 505 bei einer real hergestellten Flexodruckform nicht notwendigerweise eine streng kegelförmige beziehungsweise streng zylindrische Form aufweisen, wie in Fig. 5 dargestellt, sondern lediglich eine an einen Kegel beziehungsweise an einen Zylinder angenäherte Form. Dies ist durch den schichtweisen vertikalen Aufbau der Strukturen sowie durch die endliche Auflösung der Belichtungseinrichtungen beim selektiven Belichten der entsprechenden Schichten aus flüssigem Fotopolymer begründet.

## Patentansprüche

1. Verfahren (100) zur Herstellung einer Fotopolymerplatte (350, 500), wobei das Verfahren umfasst:
- Erzeugen (110) einer ersten Schicht (341) eines flüssigen Fotopolymers (340);
- Erzeugen (112) eines oder mehrerer gehärteter Bereiche (351) der ersten Schicht (341) durch selektives Belichten der ersten Schicht (341);
- Erzeugen (114) einer zweiten Schicht (342) des flüssigen Fotopolymers (340) auf derjenigen Seite der ersten Schicht, welche dem Lichteinfall für das selektive Belichten der ersten Schicht (341) zugewandt ist;
- Erzeugen (116) eines oder mehrerer gehärteter Bereiche (352) der zweiten Schicht (352) durch selektives Belichten der zweiten Schicht (352), wobei sich mindestens ein gehärteter Bereich (352) der zweiten Schicht mit mindestens einem gehärteten Bereich (351) der ersten Schicht verbindet.

2. Verfahren nach Anspruch 1,
wobei sich beim Erzeugen (112) des einen oder der mehreren gehärteten Bereiche (351) der ersten Schicht mindestens ein gehärteter Bereich (351) der ersten Schicht mit einer vollflächigen Trägerschicht (260, 360) verbindet.

3. Verfahren nach Anspruch 2,
wobei sich das flüssige Fotopolymer (340) in einem Gefäß (210, 310) mit einem zumindest teilweise transparenten Begrenzungselement (212, 312) befindet, wobei das Licht zum selektiven Belichten der ersten Schicht (341) und/oder zum selektiven Belichten der zweiten Schicht (342) von außen auf das zumindest teilweise transparente Begrenzungselement (212, 312) des Gefäßes (210, 310) trifft und das zumindest teilweise transparente Begrenzungselement (212, 312) zumindest teilweise durchdringt,
wobei die zweite Schicht (342) dadurch erzeugt wird, dass die Trägerschicht (260, 360) zusammen mit dem mindestens einen mit der Trägerschicht (260, 360) verbundenen gehärteten Bereich (351) der ersten Schicht so bewegt wird, dass sich der Abstand zwischen der Trägerschicht (260, 360) und dem zumindest teilweise transparenten Begrenzungselement (212, 312) vergrößert, sodass flüssiges Fotopolymer (340) in das hierdurch entstehende Volumen strömt.

4. Verfahren nach Anspruch 3,
wobei die Trägerschicht (260, 360) zusammen mit dem mindestens einen mit der Trägerschicht (260, 360) verbundenen gehärteten Bereich (351) der ersten Schicht entgegen der Schwerkraft bewegt wird.

5. Verfahren nach einem der Ansprüche 1 bis 4,
wobei für das selektive Belichten der ersten Schicht (341) und/oder das selektive Belichten der zweiten Schicht (342) mindestens eine LED, mindestens ein Laser oder mindestens eine Laserdiode als Lichtquelle (221, 321) verwendet wird.

6. Verfahren nach einem der Ansprüche 1 bis 5,
wobei für das selektive Belichten der ersten Schicht (341) und/oder das selektive Belichten der zweiten Schicht (342) ein Flächenlichtmodulator (226) oder ein Flüssigkristallbildschirm (320) verwendet wird.

7. Verfahren nach einem der Ansprüche 1 bis 6, wobei das Verfahren ferner umfasst:
- Erzeugen (118) mindestens einer weiteren Schicht (343) des flüssigen Fotopolymers (340) auf derjenigen Seite der unmittelbar zuvor erzeugten Schicht (342), welche dem Lichteinfall für das selektive Belichten der unmittelbar zuvor erzeugten Schicht (342) zugewandt ist;
- Erzeugen (120) eines oder mehrerer gehärteter Bereiche (353) der mindestens einen weiteren Schicht durch selektives Belichten der mindestens einen weiteren Schicht (343), wobei sich mindestens ein gehärteter Bereich (353) der mindestens einen weiteren Schicht mit mindestens einem gehärteten Bereich (352) der unmittelbar zuvor erzeugten Schicht verbindet.

8. Verfahren nach einem der Ansprüche 1 bis 7,
wobei mindestens ein gehärteter Bereich (252, 353) mindestens einer als letztes erzeugten Schicht eine Querschnittsfläche von höchstens 0,049 mm², bevorzugt höchstens 0,029 mm², besonders bevorzugt höchstens 0,016 mm² aufweist.

9. Verfahren nach einem der Ansprüche 1 bis 8,
wobei das Verfahren ferner mindestens einen der folgenden Schritte umfasst:
- Auswaschen und/oder Ausblasen des flüssigen Fotopolymers aus mindestens einem nicht gehärteten Bereich mindestens einer erzeugten Schicht;
- Trocknen mindestens eines gehärteten Bereichs mindestens einer erzeugten Schicht;
- Nachbelichten mindestens eines gehärteten Bereichs mindestens einer erzeugten Schicht.

10. Verfahren nach einem der Ansprüche 1 bis 9,
wobei als Fotopolymerplatte (350, 500) eine Flexodruckform (350, 500) oder eine Prägeform hergestellt wird.

11. Vorrichtung (200, 300) zur Herstellung einer Fotopolymerplatte (350, 500), insbesondere zur Durchführung eines Verfahrens (100) nach einem der Ansprüche 1 bis 10, wobei die Vorrichtung umfasst:
- ein Gefäß (210, 310) mit einem zumindest teilweise transparenten Begrenzungselement (212, 312);
- eine Belichtungseinrichtung (220, 320), welche dazu eingerichtet ist, eine Oberfläche des zumindest teilweise transparenten Begrenzungselements (212, 312) von außen selektiv zu belichten;
- eine bewegliche Halteeinrichtung (220, 230), welche dazu eingerichtet ist, eine vollflächige Trägerschicht (260, 360) der Fotopolymerplatte (350, 500) zu halten und so zu bewegen, dass sich der Abstand zwischen der Trägerschicht (260, 360) und dem zumindest teilweise transparenten Begrenzungselement (212, 312) vergrößert.

12. Vorrichtung nach Anspruch 11,
wobei die bewegliche Halteeinrichtung (220, 230) dazu eingerichtet ist, die vollflächige Trägerschicht (260, 360) der Fotopolymerplatte (350, 500) entgegen der Schwerkraft zu bewegen.

13. Vorrichtung nach Anspruch 11 oder 12,
wobei die Belichtungseinrichtung (220, 320) mindestens eine LED, mindestens einen Laser oder mindestens eine Laserdiode als Lichtquelle (221, 321) umfasst.

14. Vorrichtung nach einem der Ansprüche 12 bis 13,
wobei die Belichtungseinrichtung (220, 320) einen Flächenlichtmodulator (226) oder einen Flüssigkristallbildschirm (320) umfasst.

15. Computerprogrammprodukt, umfassend Befehle, die bei der Ausführung des Programms durch einen Prozessor eine Vorrichtung (200, 300) nach einem der Ansprüche 11 bis 14 dazu veranlassen, ein Verfahren (100) nach einem der Ansprüche 1 bis 10 auszuführen.

## Geänderte Patentansprüche

### Geänderte Patentansprüche gemäss Regel 137(2) EPÜ.

1. Verfahren (100) zur Herstellung einer Fotopolymerplatte (350, 500), wobei das Verfahren umfasst:
- Erzeugen (110) einer ersten Schicht (341) eines flüssigen Fotopolymers (340);
- Erzeugen (112) eines oder mehrerer gehärteter Bereiche (351) der ersten Schicht (341) durch selektives Belichten der ersten Schicht (341), wobei sich beim Erzeugen (112) des einen oder der mehreren gehärteten Bereiche (351) der ersten Schicht mindestens ein gehärteter Bereich (351) der ersten Schicht mit einer vollflächigen Trägerschicht (260, 360) verbindet, wobei die Trägerschicht (260, 360) eine Folie aus einem Polymer ist, bei dem im Falle einer Belichtung keine photochemische Härtung erfolgt;
- Erzeugen (114) einer zweiten Schicht (342) des flüssigen Fotopolymers (340) auf derjenigen Seite der ersten Schicht, welche dem Lichteinfall für das selektive Belichten der ersten Schicht (341) zugewandt ist;
- Erzeugen (116) eines oder mehrerer gehärteter Bereiche (352) der zweiten Schicht (352) durch selektives Belichten der zweiten Schicht (352), wobei sich mindestens ein gehärteter Bereich (352) der zweiten Schicht mit mindestens einem gehärteten Bereich (351) der ersten Schicht verbindet.

2. Verfahren nach Anspruch 1,
wobei sich das flüssige Fotopolymer (340) in einem Gefäß (210, 310) mit einem zumindest teilweise transparenten Begrenzungselement (212, 312) befindet, wobei das Licht zum selektiven Belichten der ersten Schicht (341) und/oder zum selektiven Belichten der zweiten Schicht (342) von außen auf das zumindest teilweise transparente Begrenzungselement (212, 312) des Gefäßes (210, 310) trifft und das zumindest teilweise transparente Begrenzungselement (212, 312) zumindest teilweise durchdringt,
wobei die zweite Schicht (342) dadurch erzeugt wird, dass die Trägerschicht (260, 360) zusammen mit dem mindestens einen mit der Trägerschicht (260, 360) verbundenen gehärteten Bereich (351) der ersten Schicht so bewegt wird, dass sich der Abstand zwischen der Trägerschicht (260, 360) und dem zumindest teilweise transparenten Begrenzungselement (212, 312) vergrößert, sodass flüssiges Fotopolymer (340) in das hierdurch entstehende Volumen strömt.

3. Verfahren nach Anspruch 2,
wobei die Trägerschicht (260, 360) zusammen mit dem mindestens einen mit der Trägerschicht (260, 360) verbundenen gehärteten Bereich (351) der ersten Schicht entgegen der Schwerkraft bewegt wird.

4. Verfahren nach einem der Ansprüche 1 bis 3,
wobei für das selektive Belichten der ersten Schicht (341) und/oder das selektive Belichten der zweiten Schicht (342) mindestens eine LED, mindestens ein Laser oder mindestens eine Laserdiode als Lichtquelle (221, 321) verwendet wird.

5. Verfahren nach einem der Ansprüche 1 bis 4,
wobei für das selektive Belichten der ersten Schicht (341) und/oder das selektive Belichten der zweiten Schicht (342) ein Flächenlichtmodulator (226) oder ein Flüssigkristallbildschirm (320) verwendet wird.

6. Verfahren nach einem der Ansprüche 1 bis 5, wobei das Verfahren ferner umfasst:
- Erzeugen (118) mindestens einer weiteren Schicht (343) des flüssigen Fotopolymers (340) auf derjenigen Seite der unmittelbar zuvor erzeugten Schicht (342), welche dem Lichteinfall für das selektive Belichten der unmittelbar zuvor erzeugten Schicht (342) zugewandt ist;
- Erzeugen (120) eines oder mehrerer gehärteter Bereiche (353) der mindestens einen weiteren Schicht durch selektives Belichten der mindestens einen weiteren Schicht (343), wobei sich mindestens ein gehärteter Bereich (353) der mindestens einen weiteren Schicht mit mindestens einem gehärteten Bereich (352) der unmittelbar zuvor erzeugten Schicht verbindet.

7. Verfahren nach einem der Ansprüche 1 bis 6,
wobei mindestens ein gehärteter Bereich (252, 353) mindestens einer als letztes erzeugten Schicht eine Querschnittsfläche von höchstens 0,049 mm², bevorzugt höchstens 0,029 mm², besonders bevorzugt höchstens 0,016 mm² aufweist.

8. Verfahren nach einem der Ansprüche 1 bis 7,
wobei das Verfahren ferner mindestens einen der folgenden Schritte umfasst:
- Auswaschen und/oder Ausblasen des flüssigen Fotopolymers aus mindestens einem nicht gehärteten Bereich mindestens einer erzeugten Schicht;
- Trocknen mindestens eines gehärteten Bereichs mindestens einer erzeugten Schicht;
- Nachbelichten mindestens eines gehärteten Bereichs mindestens einer erzeugten Schicht.

9. Verfahren nach einem der Ansprüche 1 bis 8,
wobei als Fotopolymerplatte (350, 500) eine Flexodruckform (350, 500) oder eine Prägeform hergestellt wird.

10. Vorrichtung (200, 300) zur Herstellung einer Fotopolymerplatte (350, 500), insbesondere zur Durchführung eines Verfahrens (100) nach einem der Ansprüche 1 bis 9, wobei die Vorrichtung umfasst:
- ein Gefäß (210, 310) mit einem zumindest teilweise transparenten Begrenzungselement (212, 312);
- eine Belichtungseinrichtung (220, 320), welche dazu eingerichtet ist, eine Oberfläche des zumindest teilweise transparenten Begrenzungselements (212, 312) von außen selektiv zu belichten;
- eine bewegliche Halteeinrichtung (220, 230), welche dazu eingerichtet ist, eine vollflächige Trägerschicht (260, 360) der Fotopolymerplatte (350, 500) zu halten und so zu bewegen, dass sich der Abstand zwischen der Trägerschicht (260, 360) und dem zumindest teilweise transparenten Begrenzungselement (212, 312) vergrößert, wobei die Trägerschicht (260, 360) eine Folie aus einem Polymer ist, bei dem im Falle einer Belichtung keine photochemische Härtung erfolgt.

11. Vorrichtung nach Anspruch 10,
wobei die bewegliche Halteeinrichtung (220, 230) dazu eingerichtet ist, die vollflächige Trägerschicht (260, 360) der Fotopolymerplatte (350, 500) entgegen der Schwerkraft zu bewegen.

12. Vorrichtung nach Anspruch 10 oder 11,
wobei die Belichtungseinrichtung (220, 320) mindestens eine LED, mindestens einen Laser oder mindestens eine Laserdiode als Lichtquelle (221, 321) umfasst.

13. Vorrichtung nach einem der Ansprüche 11 bis 12,
wobei die Belichtungseinrichtung (220, 320) einen Flächenlichtmodulator (226) oder einen Flüssigkristallbildschirm (320) umfasst.

14. Computerprogrammprodukt, umfassend Befehle, die bei der Ausführung des Programms durch einen Prozessor eine Vorrichtung (200, 300) nach einem der Ansprüche 10 bis 13 dazu veranlassen, ein Verfahren (100) nach einem der Ansprüche 1 bis 9 auszuführen.
